# EUROPEAN PATENT APPLICATION

(11) **EP 2 680 327 A2**
(43) Date of publication of application: **01.01.2014**
(21) Application number: 13174289.2
(22) Date of filing: 28.06.2013
(51) Int. Cl.: H01L 33/46, H01L 33/50

(54) **Reflecting layer-phosphor layer-covered LED, producing method thereof, LED device, and producing method thereof**

(30) Priority: 29.06.2012 JP 2012147552; 30.01.2013 JP 2013015780
(71) Applicant: NITTO DENKO CORPORATION, Ibaraki-shi, Osaka 567-8680 (JP)
(72) Inventor: Katayama, Hiroyuki, Osaka, 567-8680 (JP); Kimura, Ryuichi, Osaka, 567-8680 (JP); Ebe, Yuki, Osaka, 567-8680 (JP); Onishi, Hidenori, Osaka, 567-8680 (JP); Fuke, Kazuhiro, Osaka, 567-8680 (JP)
(74) Representative: HOFFMANN EITLE

(57) **Abstract**

A method for producing a reflecting layer-phosphor layer-covered LED include a disposing step of disposing a reflecting layer at one side in a thickness direction of a support; a reflecting layer covering step of, after the disposing step, disposing an LED having a terminal at one surface thereof at the one side in the thickness direction of the support so as to allow the one surface of the LED to be covered with the reflecting layer; and a phosphor layer covering step of forming a phosphor layer so as to cover at least the other surface of the LED.

## Description

BACKGROUND OF THE INVENTION

### Field of the Invention

The present invention relates to a reflecting layer-phosphor layer-covered LED, a producing method thereof, an LED device, and a producing method thereof, to be specific, to a method for producing a reflecting layer-phosphor layer-covered LED, a reflecting layer-phosphor layer-covered LED obtained by the method, a method for producing an LED device using the reflecting layer-phosphor layer-covered LED, and an LED device obtained by the method.

### Description of Related Art

It has been known that, conventionally, a light emitting diode device (hereinafter, abbreviated as an LED device) is produced as follows: first, a plurality of light emitting diode elements (hereinafter, abbreviated as LEDs) are mounted on a board; next, a phosphor layer is provided so as to cover a plurality of the LEDs; and thereafter, the resulting products are singulated into individual LEDs.

Unevenness in emission wavelength and luminous efficiency is generated between a plurality of the LEDs, however, so that in such an LED device mounted with the LED, there is a disadvantage that unevenness in light emission is generated between a plurality of the LEDs.

In order to solve such a disadvantage, it has been considered that, for example, a plurality of LEDs are covered with a phosphor layer to fabricate a plurality of phosphor layer-covered LEDs and thereafter, the phosphor layer-covered LED is selected in accordance with the emission wavelength and the luminous efficiency to be then mounted on a board.

For example, a ceramic-covered LED obtained by the following method has been proposed (ref: for example, Japanese Unexamined Patent Publication No. 2012-39013). In the method, an LED is disposed on a pressure-sensitive adhesive sheet; next, a ceramic ink in which a phosphor is dispersed and mixed is applied onto the pressure-sensitive adhesive sheet so as to cover the surface of the LED to be heated, so that the ceramic ink is temporarily cured; thereafter, the ceramic ink is subjected to dicing corresponding to the LED; and then, the obtained ceramic ink is fully cured by heating to be vitrified so as to produce the ceramic-covered LED. The ceramic-covered LED is to be then mounted on a board, so that an LED device is obtained.

### SUMMARY OF THE INVENTION

In the LED device obtained by the method described in Japanese Unexamined Patent Publication No. 2012-39013, there is a disadvantage that sufficient luminous efficiency is not capable of being obtained.

It is an object of the present invention to provide an LED device having excellent luminous efficiency, a producing method thereof, a reflecting layer-phosphor layer-covered LED used therein, and a producing method thereof.

A method for producing a reflecting layer-phosphor layer-covered LED of the present invention includes a disposing step of disposing a reflecting layer at one side in a thickness direction of a support; a reflecting layer covering step of, after the disposing step, disposing an LED having a terminal at one surface thereof at the one side in the thickness direction of the support so as to allow the one surface of the LED to be covered with the reflecting layer; and a phosphor layer covering step of forming a phosphor layer so as to cover at least the other surface of the LED.

In the method for producing a reflecting layer-phosphor layer-covered LED of the present invention, it is preferable that the phosphor layer is formed of a phosphor sheet.

In the method for producing a reflecting layer-phosphor layer-covered LED of the present invention, it is preferable that in the disposing step, the reflecting layer that is in a B-stage state is provided and in the reflecting layer covering step, the one surface of the LED is allowed to adhere to the reflecting layer in a B-stage state.

In the method for producing a reflecting layer-phosphor layer-covered LED of the present invention, it is preferable that after the phosphor layer covering step, a peeling step in which the reflecting layer-phosphor layer-covered LED is peeled from the support is further included.

In the method for producing a reflecting layer-phosphor layer-covered LED of the present invention, it is preferable that the support is a support sheet including a hard support board and the phosphor layer covering step further includes a layer disposing step of disposing a phosphor layer formed from a phosphor resin composition containing a curable resin and a phosphor at one side in the thickness direction of the support sheet so as to cover the LED; an encapsulating step of curing the phosphor layer to encapsulate the LED by the phosphor layer that is flexible; and a cutting step of, after the encapsulating step, cutting the phosphor layer that is flexible corresponding to the LED to produce a reflecting layer-phosphor layer-covered LED.

In the method for producing a reflecting layer-phosphor layer-covered LED of the present invention, it is preferable that the support sheet further includes a pressure-sensitive adhesive layer that is laminated at the one surface in the thickness direction of the support board.

In the method for producing a reflecting layer-phosphor layer-covered LED of the present invention, it is preferable that in the peeling step, the reflecting layer-phosphor layer-covered LED is peeled from the support board and the pressure-sensitive adhesive layer.

In the method for producing a reflecting layer-phosphor layer-covered LED of the present invention, it is preferable that after the cutting step and before the peeling step, a support board peeling step in which the support board is peeled from the pressure-sensitive adhesive layer is further included and in the peeling step, the reflecting layer-phosphor layer-covered LED is peeled from the pressure-sensitive adhesive layer.

In the method for producing a reflecting layer-phosphor layer-covered LED of the present invention, it is preferable that after the peeling step and before the cutting step, a support board peeling step in which the support board is peeled from the pressure-sensitive adhesive layer is further included and in the peeling step, the reflecting layer-phosphor layer-covered LED is peeled from the pressure-sensitive adhesive layer.

In the method for producing a reflecting layer-phosphor layer-covered LED of the present invention, it is preferable that the peeling step includes the steps of transferring the reflecting layer-phosphor layer-covered LED to a stretchable support sheet that is capable of stretching in a direction perpendicular to the thickness direction and peeling the reflecting layer-phosphor layer-covered LED from the stretchable support sheet, while stretching the stretchable support sheet in the direction perpendicular to the thickness direction.

In the method for producing a reflecting layer-phosphor layer-covered LED of the present invention, it is preferable that the support is a support sheet and the phosphor layer covering step further includes a layer disposing step of disposing a phosphor layer formed from a phosphor resin composition containing an active energy ray curable resin that is capable of being cured by application of an active energy ray and a phosphor at the one side in the thickness direction of the support sheet so as to cover the LED; an encapsulating step of applying an active energy ray to the phosphor layer to encapsulate the LED by the phosphor layer; and a cutting step of cutting the phosphor layer corresponding to the LED.

In the method for producing a reflecting layer-phosphor layer-covered LED of the present invention, it is preferable that the support sheet is capable of stretching in a direction perpendicular to the thickness direction and in the peeling step, the reflecting layer-phosphor layer-covered LED is peeled from the support sheet, while the support sheet is stretched in the direction perpendicular to the thickness direction.

In the method for producing a reflecting layer-phosphor layer-covered LED of the present invention, it is preferable that the support sheet is a thermal release sheet in which the pressure-sensitive adhesive force is capable of being reduced by heating and in the peeling step, the support sheet is heated and the reflecting layer-phosphor layer-covered LED is peeled from the support sheet.

In the method for producing a reflecting layer-phosphor layer-covered LED of the present invention, it is preferable that the support is a support sheet including a hard support board and a pressure-sensitive adhesive layer that is laminated at the one surface in the thickness direction of the support board and in which the pressure-sensitive adhesive force is capable of being reduced by application of an active energy ray; the phosphor layer covering step includes an encapsulating step of disposing the phosphor layer at the one surface in the thickness direction of the support board so as to cover the LED to encapsulate the LED by the phosphor layer and a cutting step of, after the encapsulating step, cutting the phosphor layer corresponding to the LED; and in the peeling step, an active energy ray is applied from at least the one side in the thickness direction to the pressure-sensitive adhesive layer and the reflecting layer-phosphor layer-covered LED is peeled from the pressure-sensitive adhesive layer.

In the method for producing a reflecting layer-phosphor layer-covered LED of the present invention, it is preferable that the support is a support sheet including a hard support board in which a through hole passing through in the thickness direction is formed and a pressure-sensitive adhesive layer that is laminated at the one side in the thickness direction of the support board so as to cover the through hole and in the reflecting layer covering step, the LED is opposed to the through hole in the thickness direction and in the peeling step, a pressing member is inserted into the through hole from the other side in the thickness direction thereof and the pressure-sensitive adhesive layer corresponding to the through hole is pressed relatively toward the one side in the thickness direction with respect to the support board, so that the reflecting layer-phosphor layer-covered LED is peeled from the pressure-sensitive adhesive layer, while the reflecting layer-phosphor layer-covered LED is moved relatively to the one side in the thickness direction.

In the method for producing a reflecting layer-phosphor layer-covered LED of the present invention, it is preferable that the phosphor layer covering step further includes a layer disposing step of disposing a phosphor layer formed from a phosphor resin composition containing a curable resin and a phosphor at the one side in the thickness direction of the support so as to cover the LED; an encapsulating step of curing the phosphor layer to encapsulate the LED by the phosphor layer that is flexible; and a cutting step of, after the encapsulating step, cutting the phosphor layer that is flexible corresponding to the LED to produce a reflecting layer-phosphor layer-covered LED.

In the method for producing a reflecting layer-phosphor layer-covered LED of the present invention, it is preferable that in the disposing step, the prepared support sheet is used so that a reference mark, which serves as a reference of cutting in the cutting step, is provided in advance.

In the method for producing a reflecting layer-phosphor layer-covered LED of the present invention, it is preferable that in the disposing step, the reflecting layer is provided in a pattern of corresponding to the one surface of the LED.

In the method for producing a reflecting layer-phosphor layer-covered LED of the present invention, it is preferable that in the disposing step, the reflecting layer is provided on the entire surface at the one side in the thickness direction of the support.

In the method for producing a reflecting layer-phosphor layer-covered LED of the present invention, it is preferable that in the disposing step, the reflecting layer is provided by laminating a reflecting sheet formed from a reflecting resin composition on the support.

In the method for producing a reflecting layer-phosphor layer-covered LED of the present invention, it is preferable that in the disposing step, the reflecting layer is provided by applying a liquid reflecting resin composition to the support.

In the method for producing a reflecting layer-phosphor layer-covered LED of the present invention, it is preferable that the phosphor layer includes a cover portion that covers the LED and a reflector portion that contains a light reflecting component and is formed so as to surround the cover portion.

A reflecting layer-phosphor layer-covered LED of the present invention is obtained by a method for producing a reflecting layer-phosphor layer-covered LED including a disposing step of disposing a reflecting layer at one side in a thickness direction of a support; a reflecting layer covering step of, after the disposing step, disposing an LED having a terminal at one surface thereof at the one side in the thickness direction of the support so as to allow the one surface of the LED to be covered with the reflecting layer; and a phosphor layer covering step of forming a phosphor layer so as to cover at least the other surface of the LED.

A method for producing an LED device of the present invention includes the steps of obtaining a reflecting layer-phosphor layer-covered LED by a method for producing a reflecting layer-phosphor layer-covered LED including a disposing step of disposing a reflecting layer at one side in a thickness direction of a support; a reflecting layer covering step of, after the disposing step, disposing an LED having a terminal at one surface thereof at the one side in the thickness direction of the support so as to allow the one surface of the LED to be covered with the reflecting layer; a phosphor layer covering step of forming a phosphor layer so as to cover at least the other surface of the LED; and a peeling step of, after the phosphor layer covering step, peeling a reflecting layer-phosphor layer-covered LED from the support and mounting the reflecting layer-phosphor layer-covered LED on a board via the terminal.

An LED device of the present invention is obtained by a method for producing an LED device including a disposing step of disposing a reflecting layer at one side in a thickness direction of a support; a reflecting layer covering step of, after the disposing step, disposing an LED having a terminal at one surface thereof at the one side in the thickness direction of the support so as to allow the one surface of the LED to be covered with the reflecting layer; a phosphor layer covering step of forming a phosphor layer so as to cover at least the other surface of the LED; and a peeling step of, after the phosphor layer covering step, peeling a reflecting layer-phosphor layer-covered LED from the support.

A method for producing an LED device of the present invention is obtained by a method for producing a reflecting layer-phosphor layer-covered LED including a disposing step of disposing a reflecting layer at one side in a thickness direction of a support; a reflecting layer covering step of, after the disposing step, disposing an LED having a terminal at one surface thereof at the one side in the thickness direction of the support so as to allow the one surface of the LED to be covered with the reflecting layer; and a phosphor layer covering step of forming a phosphor layer so as to cover at least the other surface of the LED, wherein the phosphor layer covering step is performed before the reflecting layer covering step; the support is a board; and in the reflecting layer covering step, the LED is mounted on the board via the terminal.

In the method for producing an LED device of the present invention, it is preferable that in the disposing step, the reflecting layer is provided in a pattern of corresponding to the one surface of the LED.

In the method for producing an LED device of the present invention, it is preferable that in the disposing step, the reflecting layer is provided on the entire surface at the one side in the thickness direction of the support.

In the method for producing an LED device of the present invention, it is preferable that in the disposing step, the reflecting layer is provided by laminating a reflecting sheet formed from a reflecting resin composition on the support.

In the method for producing an LED device of the present invention, it is preferable that in the disposing step, the reflecting layer is provided by applying a liquid reflecting resin composition to the support.

An LED device of the present invention is obtained by a method for producing an LED device by a method for producing a reflecting layer-phosphor layer-covered LED including a disposing step of disposing a reflecting layer at one side in a thickness direction of a support; a reflecting layer covering step of, after the disposing step, disposing an LED having a terminal at one surface thereof at the one side in the thickness direction of the support so as to allow the one surface of the LED to be covered with the reflecting layer; and a phosphor layer covering step of forming a phosphor layer so as to cover at least the other surface of the LED, wherein the phosphor layer covering step is performed before the reflecting layer covering step; the support is a board; and in the reflecting layer covering step, the LED is mounted on the board via the terminal.

A reflecting layer-phosphor layer-covered LED of the present invention includes an LED having a terminal at one surface thereof, a reflecting layer formed so as to cover the one surface of the LED, and a phosphor layer formed so as to cover at least the other surface of the LED.

In the reflecting layer-phosphor layer-covered LED of the present invention, it is preferable that the phosphor layer is formed so as to also cover a continuous surface that is continuous to the one surface and the other surface of the LED.

According to the method for producing a reflecting layer-phosphor layer-covered LED of the present invention, the LED having a terminal at one surface thereof is disposed at one side in the thickness direction of the support so as to allow the one surface of the LED to be covered with the reflecting layer and the phosphor layer is formed so as to cover at least the other surface of the LED. Thus, in the reflecting layer-phosphor layer-covered LED of the present invention, the reflecting layer is formed at the one surface of the LED and the phosphor layer is formed at the other surface of the LED.

Thus, in the LED device of the present invention obtained by mounting the reflecting layer-phosphor layer-covered LED on the board via the terminal, light applied toward the other side of the LED transmits through the phosphor layer and the wavelength thereof is converted by the phosphor layer. On the other hand, light applied toward the one side of the LED is reflected by the reflecting layer and goes toward the other side. That is, it is prevented that the light is applied from the LED toward the board to be absorbed in the board, and the amount of light going toward the other side can be increased.

As a result, the LED device of the present invention has excellent luminous efficiency.

### BRIEF DESCRIPTION OF THE DRAWINGS

FIG. 1 shows process drawings for illustrating a first embodiment of a method for producing a reflecting layer-phosphor layer-covered LED of the present invention:
FIG. 1 (a) illustrating a step of preparing a support sheet,
FIG. 1 (b) illustrating a step of disposing reflecting layers on the support sheet (a disposing step),
FIG. 1 (c) illustrating a step of disposing LEDs on the support sheet so that the lower surfaces of the LEDs are covered with the reflecting layers (a reflecting layer covering step),
FIG. 1 (d) illustrating a step of disposing a phosphor sheet on the support sheet (a sheet disposing step),
FIG. 1 (e) illustrating a step of curing the phosphor sheet to encapsulate the LEDs by the phosphor sheet (an encapsulating step) and a step of cutting the phosphor sheet corresponding to the LEDs (a cutting step),
FIG. 1 (f) illustrating a step of peeling reflecting layer-phosphor layer-covered LEDs from the support sheet (a peeling step), and
FIG. 1 (g) illustrating a step of mounting the reflecting layer-phosphor layer-covered LED on a board (a mounting step).
FIG. 2 shows a plan view of the support sheet shown in FIG. 1 (a).
FIG. 3 shows process drawings for illustrating a second embodiment of a method for producing a reflecting layer-phosphor layer-covered LED of the present invention:
FIG. 3 (a) illustrating a step of preparing a support sheet,
FIG. 3 (b) illustrating a step of disposing reflecting layers on the support sheet (a disposing step),
FIG. 3 (c) illustrating a step of disposing LEDs on the support sheet so that the lower surfaces of the LEDs are covered with the reflecting layers (a reflecting layer covering step),
FIG. 3 (d) illustrating a step of disposing a phosphor sheet on the support sheet (a sheet disposing step),
FIG. 3 (e) illustrating a step of curing the phosphor sheet to encapsulate the LEDs by the phosphor sheet (an encapsulating step) and a step of cutting the phosphor sheet corresponding to the LEDs (a cutting step),
FIG. 3 (f) illustrating a step of peeling a support board from a pressure-sensitive adhesive layer (a support board peeling step),
FIG. 3 (g) illustrating a step of peeling reflecting layer-phosphor layer-covered LEDs from the pressure-sensitive adhesive layer,

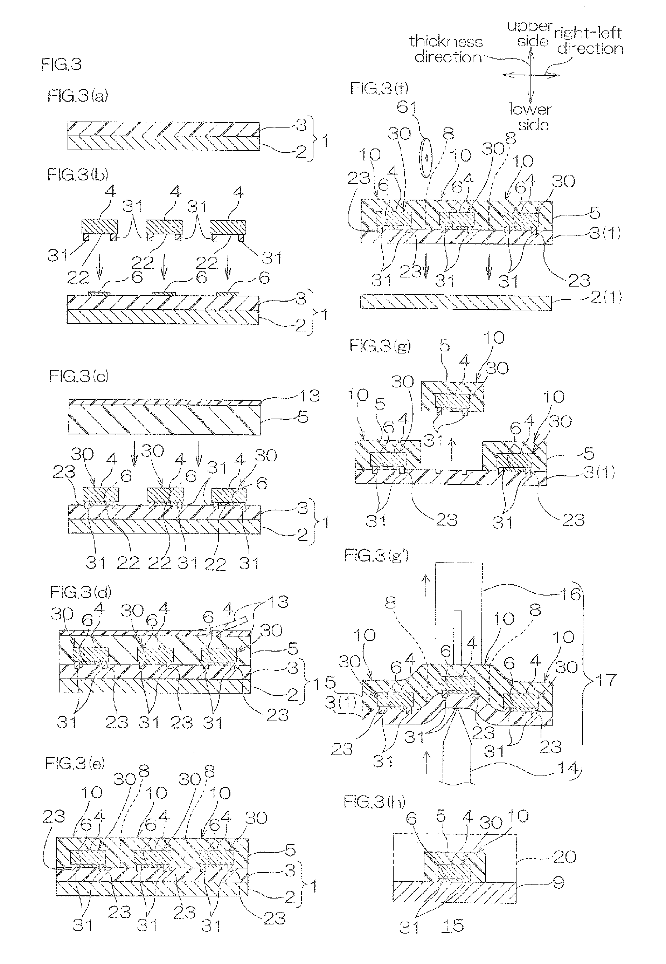

FIG. 3 (g') illustrating a step of describing the details of a state of peeling the reflecting layer-phosphor layer-covered LEDs from the pressure-sensitive adhesive layer using a pick-up device in the peeling step in FIG. 3 (g), and
FIG. 3 (h) illustrating a step of mounting the reflecting layer-phosphor layer-covered LED on a board (a mounting step).

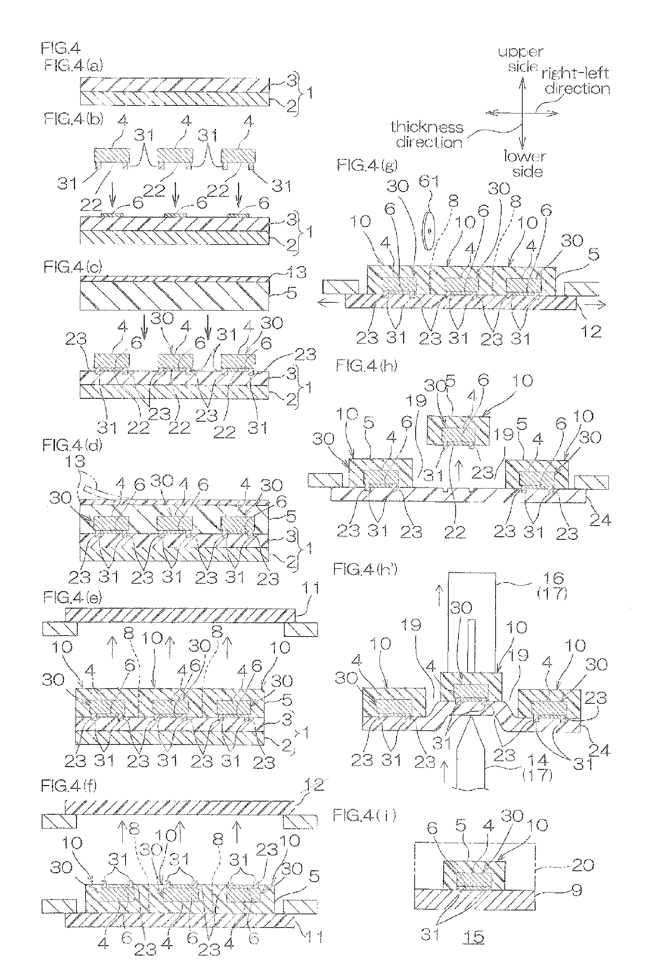

FIG. 4 shows process drawings for illustrating a third embodiment of a method for producing a reflecting layer-phosphor layer-covered LED of the present invention:
FIG. 4 (a) illustrating a step of preparing a support sheet,
FIG. 4 (b) illustrating a step of disposing reflecting layers on the support sheet (a disposing step),
FIG. 4 (c) illustrating a step of disposing LEDs on the support sheet so that the lower surfaces of the LEDs are covered with the reflecting layers (a reflecting layer covering step),
FIG. 4 (d) illustrating a step of disposing a phosphor sheet on the support sheet (a sheet disposing step),
FIG. 4 (e) illustrating a step of curing the phosphor sheet to encapsulate the LEDs by the phosphor sheet (an encapsulating step) and a step of cutting the phosphor sheet corresponding to the LEDs (a cutting step),
FIG. 4 (f) illustrating a step of transferring reflecting layer-phosphor layer-covered LEDs onto a transfer sheet,
FIG. 4 (g) illustrating a step of transferring the reflecting layer-phosphor layer-covered LEDs onto a stretchable support sheet,
FIG. 4 (h) illustrating a step of peeling the reflecting layer-phosphor layer-covered LEDs from the stretchable support sheet,
FIG. 4 (h') illustrating a step of describing the details of a state of peeling the reflecting layer-phosphor layer-covered LEDs from the stretchable support sheet using a pick-up device in the peeling step in FIG. 4 (h), and
FIG. 4 (i) illustrating a step of mounting the reflecting layer-phosphor layer-covered LED on a board (a mounting step).

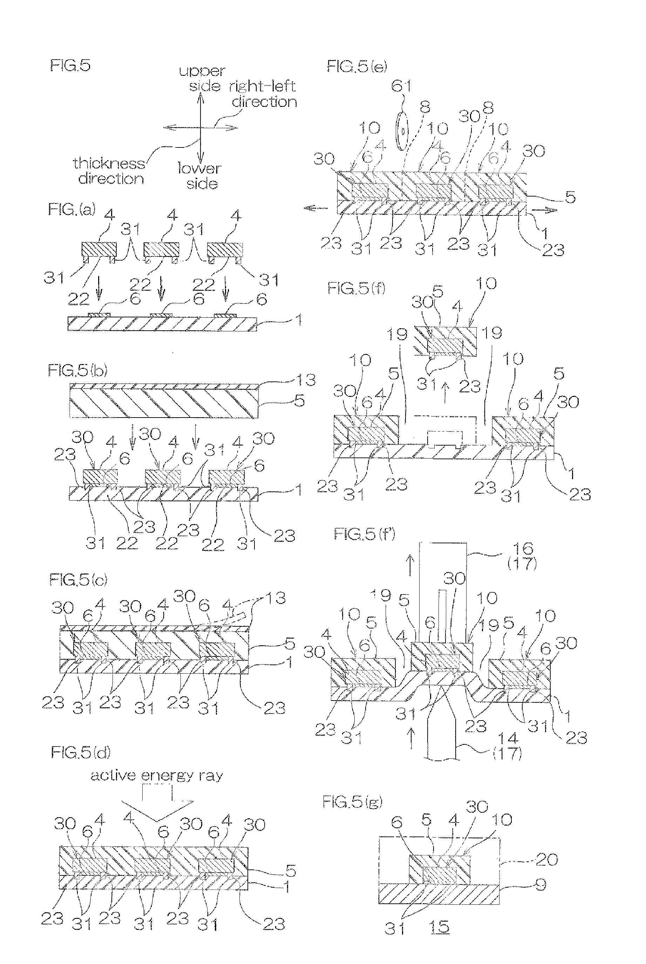

FIG. 5 shows process drawings for illustrating a fourth embodiment of a method for producing a reflecting layer-phosphor layer-covered LED of the present invention:
FIG. 5 (a) illustrating a step of disposing reflecting layers on a support sheet (a disposing step),
FIG. 5 (b) illustrating a step of disposing LEDs on the support sheet so that the lower surfaces of the LEDs are covered with the reflecting layers (a reflecting layer covering step),
FIG. 5 (c) illustrating a step of disposing a phosphor sheet on the support sheet (a sheet disposing step),
FIG. 5 (d) illustrating a step of curing the phosphor sheet to encapsulate the LEDs by the phosphor sheet (an encapsulating step),
FIG. 5 (e) illustrating a step of cutting the phosphor sheet corresponding to the LEDs (a cutting step),
FIG. 5 (f) illustrating a step of peeling reflecting layer-phosphor layer-covered LEDs from the support sheet (a peeling step),
FIG. 5 (f') illustrating a step of describing the details of a state of peeling the reflecting layer-phosphor layer-covered LEDs from the support sheet using a pick-up device in the peeling step in FIG. 5 (h), and
FIG. 5 (g) illustrating a step of mounting the reflecting layer-phosphor layer-covered LED on a board (a mounting step).

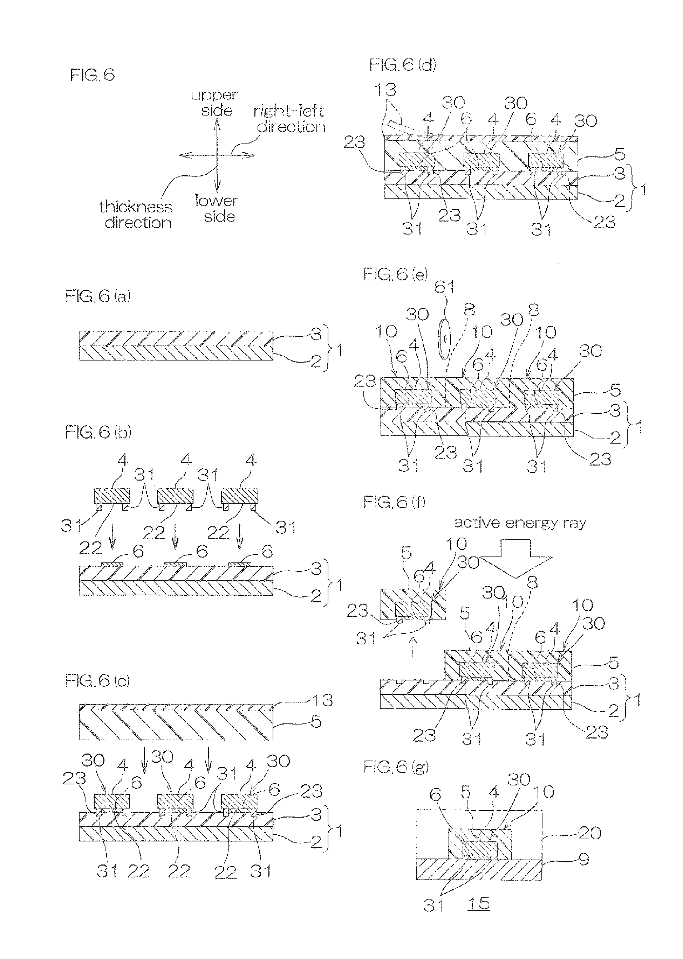

FIG. 6 shows process drawings for illustrating a fifth embodiment of a method for producing a reflecting layer-phosphor layer-covered LED of the present invention:
FIG. 6 (a) illustrating a step of preparing a support sheet,
FIG. 6 (b) illustrating a step of disposing reflecting layers on the support sheet (a disposing step),
FIG. 6 (c) illustrating a step of disposing LEDs on the support sheet so that the lower surfaces of the LEDs are covered with the reflecting layers (a reflecting layer covering step),
FIG. 6 (d) illustrating a step of disposing a phosphor sheet on the support sheet (a sheet disposing step),
FIG. 6 (e) illustrating a step of curing the phosphor sheet to encapsulate the LEDs by the phosphor sheet (an encapsulating step) and a step of cutting the phosphor sheet corresponding to the LEDs (a cutting step),
FIG. 6 (f) illustrating a step of peeling reflecting layer-phosphor layer-covered LEDs from the support sheet (a peeling step), and
FIG. 6 (g) illustrating a step of mounting the reflecting layer-phosphor layer-covered LED on a board (a mounting step).

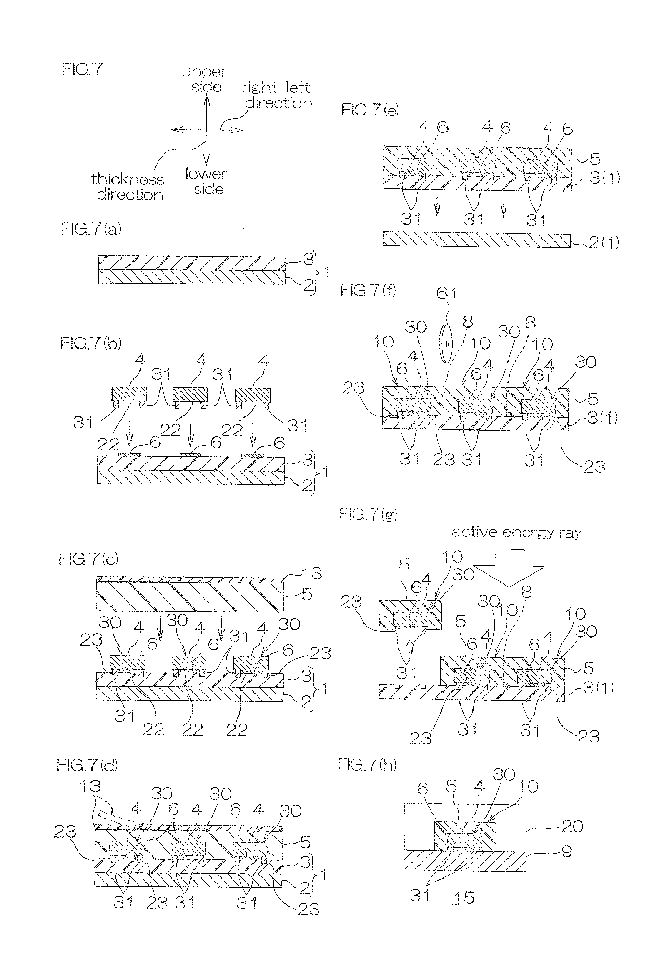

FIG. 7 shows process drawings for illustrating a sixth embodiment of a method for producing a reflecting layer-phosphor layer-covered LED of the present invention:
FIG. 7 (a) illustrating a step of preparing a support sheet,
FIG. 7 (b) illustrating a step of disposing reflecting layers on the support sheet (a disposing step),
FIG. 7 (c) illustrating a step of disposing LEDs on the support sheet so that the lower surfaces of the LEDs are covered with the reflecting layers (a reflecting layer covering step),
FIG. 7 (d) illustrating a step of disposing a phosphor sheet on the support sheet (a sheet disposing step),
FIG. 7 (e) illustrating a step of curing the phosphor sheet to encapsulate the LEDs by the phosphor sheet (an encapsulating step) and a step of peeling a support board from a pressure-sensitive adhesive layer (a support board peeling step),
FIG. 7 (f) illustrating a step of cutting the phosphor sheet corresponding to the LEDs (a cutting step),
FIG. 7 (g) illustrating a step of peeling reflecting layer-phosphor layer-covered LEDs from the support sheet (a peeling step), and
FIG. 7 (h) illustrating a step of mounting the reflecting layer-phosphor layer-covered LED on a board (a mounting step).

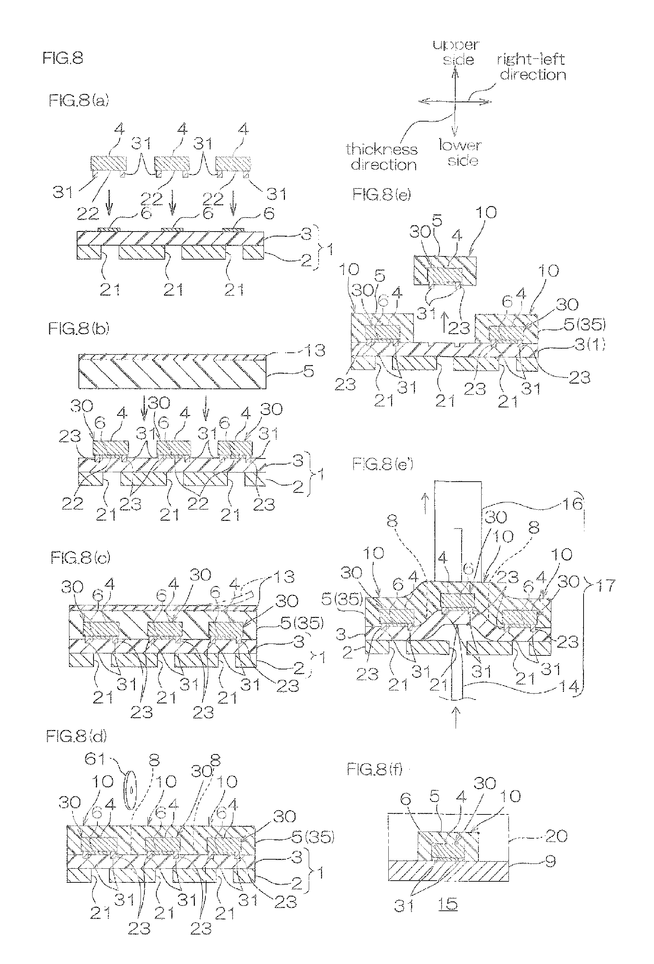

FIG. 8 shows process drawings for illustrating a seventh embodiment of a method for producing a reflecting layer-phosphor layer-covered LED of the present invention:
FIG. 8 (a) illustrating a step of disposing reflecting layers on a support sheet (a disposing step),
FIG. 8 (b) illustrating a step of disposing LEDs on the support sheet so that the lower surfaces of the LEDs are covered with the reflecting layers (a reflecting layer covering step),
FIG. 8 (c) illustrating a step of disposing a phosphor sheet on the support sheet (a sheet disposing step),
FIG. 8 (d) illustrating a step of curing the phosphor sheet to encapsulate the LEDs by the phosphor sheet (an encapsulating step) and a step of cutting the phosphor sheet corresponding to the LEDs (a cutting step),
FIG. 8 (e) illustrating a step of peeling reflecting layer-phosphor layer-covered LEDs from the support sheet,
FIG. 8 (e') illustrating a step of describing the details of a state of peeling the reflecting layer-phosphor layer-covered LEDs from the support sheet using a pick-up device in the peeling step in FIG. 8 (e), and
FIG. 8 (f) illustrating a step of mounting the reflecting layer-phosphor layer-covered LED on a board (a mounting step).

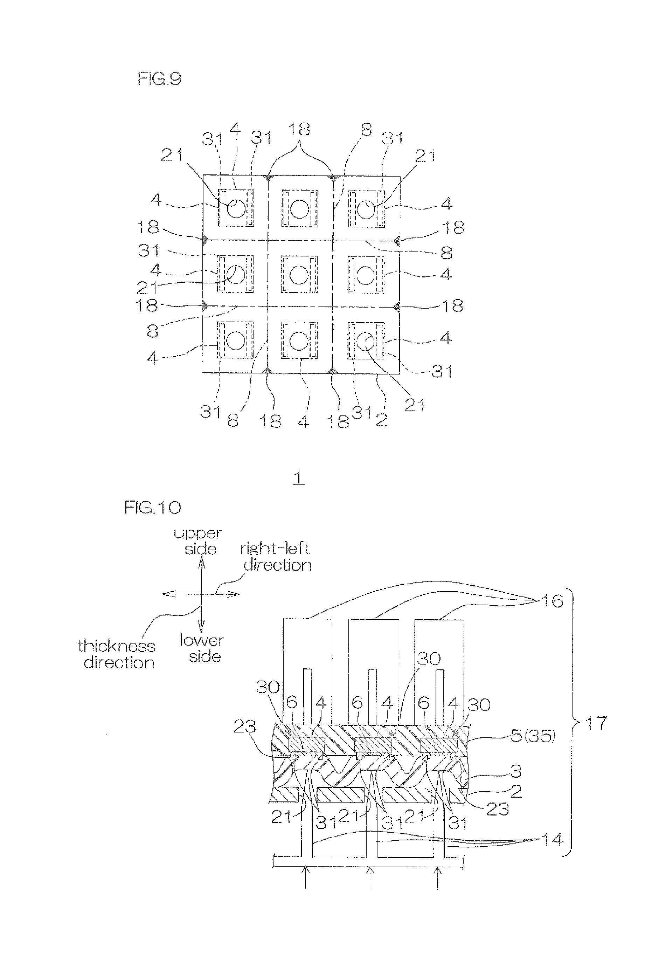

FIG. 9 shows a plan view of the support sheet shown in FIG. 8 (a).
FIG. 10 shows a modified example of the peeling step shown in FIGS. 8 (e) and 8 (e') and shows a modified example of peeling phosphor sheet-reflecting layer-covered LEDs that are not singulated.

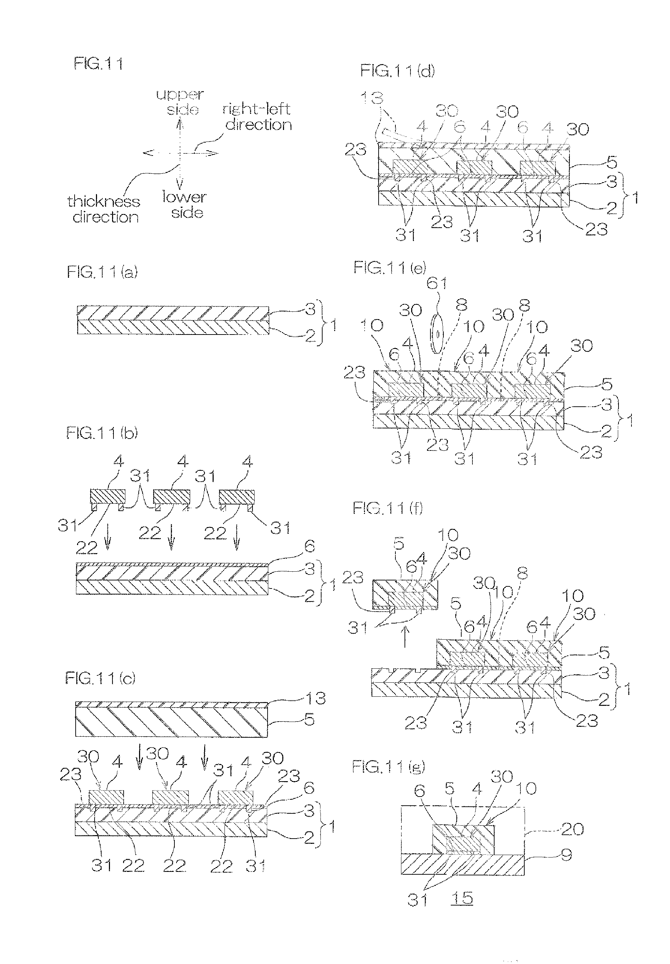

FIG. 11 shows process drawings for illustrating an eighth embodiment of a method for producing a reflecting layer-phosphor layer-covered LED of the present invention:
FIG. 11 (a) illustrating a step of preparing a support sheet,
FIG. 11 (b) illustrating a step of disposing a reflecting layer on the entire upper surface of the support sheet (a disposing step),
FIG. 11 (c) illustrating a step of disposing LEDs on the support sheet so that the lower surfaces of the LEDs are covered with the reflecting layer (a reflecting layer covering step),
FIG. 11 (d) illustrating a step of disposing a phosphor sheet on the support sheet (a sheet disposing step),
FIG. 11 (e) illustrating a step of curing the phosphor sheet to encapsulate the LEDs by the phosphor sheet (an encapsulating step) and a step of cutting the phosphor sheet corresponding to the LEDs (a cutting step),
FIG. 11 (f) illustrating a step of peeling reflecting layer-phosphor layer-covered LEDs from the support sheet (a peeling step), and
FIG. 11 (g) illustrating a step of mounting the reflecting layer-phosphor layer-covered LED on a board (a mounting step).

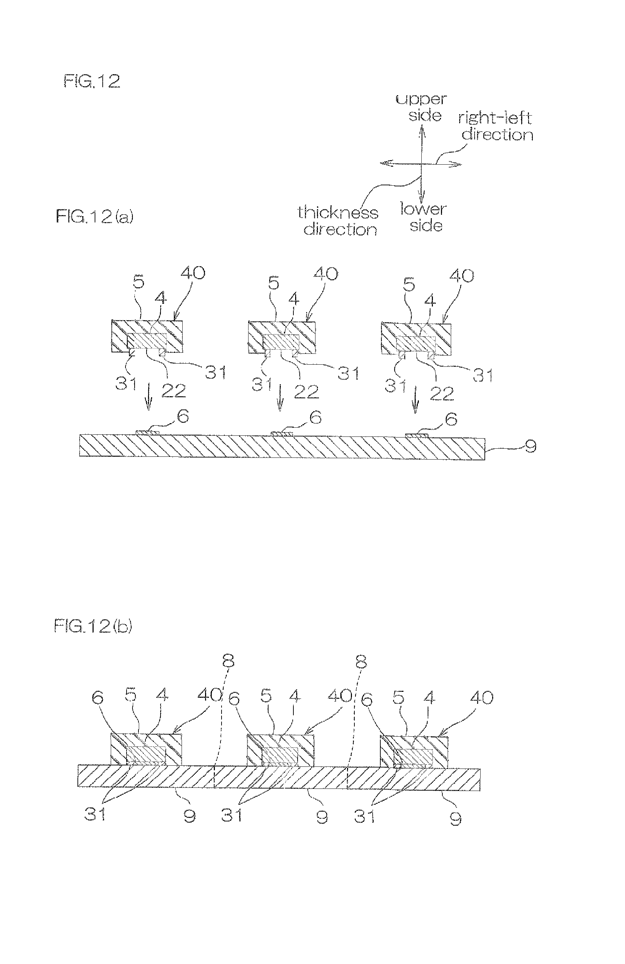

FIG. 12 shows process drawings for illustrating a ninth embodiment of a method for producing a reflecting layer-phosphor layer-covered LED of the present invention:
FIG. 12 (a) illustrating a step of preparing phosphor layer-covered LEDs (a phosphor layer covering step) and a step of disposing reflecting layers on a board (a disposing step) and
FIG. 12 (b) illustrating a step of disposing the phosphor layer-covered LEDs on the board so that the lower surfaces of LEDs are covered with the reflecting layers (a reflecting layer covering step).

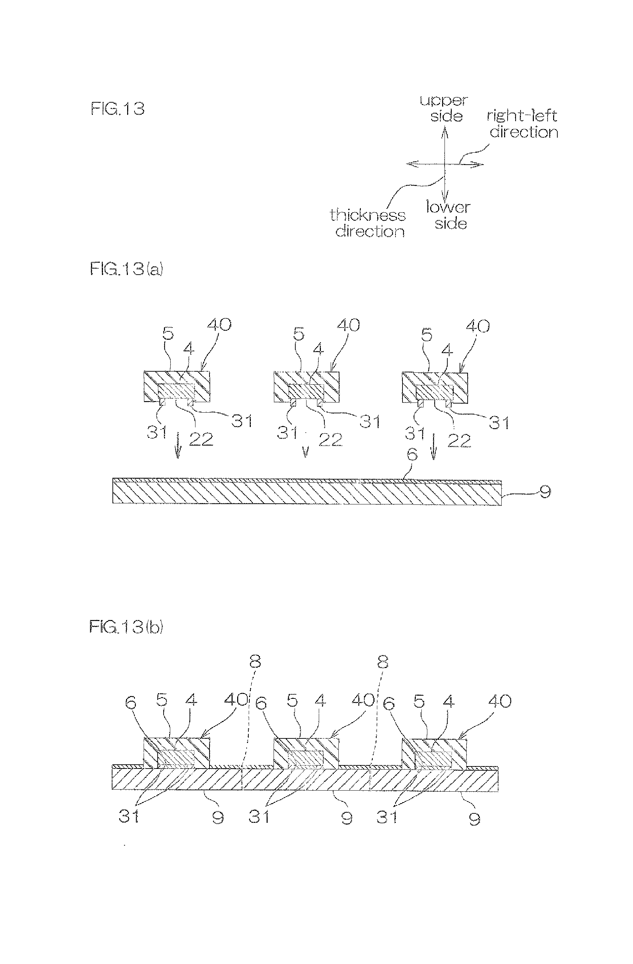

FIG. 13 shows process drawings for illustrating a tenth embodiment of a method for producing a reflecting layer-phosphor layer-covered LED of the present invention:
FIG. 13 (a) illustrating a step of preparing phosphor layer-covered LEDs (a phosphor layer covering step) and a step of disposing a reflecting layer on the entire upper surface of a board (a disposing step) and
FIG. 13 (b) illustrating a step of disposing the phosphor layer-covered LEDs on the board so that the lower surfaces of the LEDs are covered with the reflecting layer (a reflecting layer covering step).

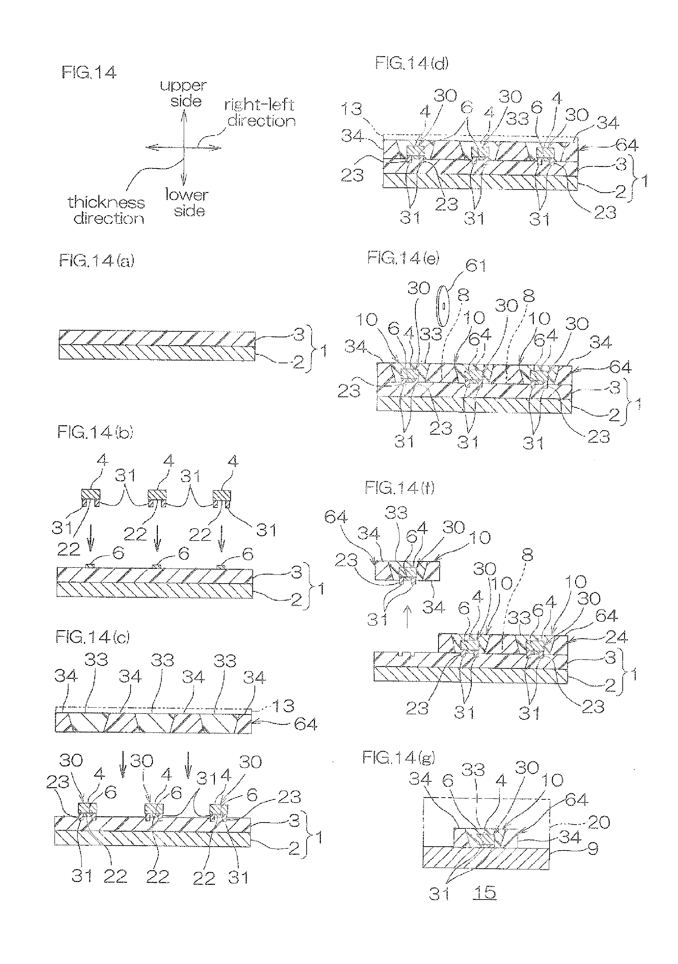

FIG. 14 shows process drawings for illustrating an eleventh embodiment of a method for producing a reflecting layer-phosphor layer-covered LED of the present invention:
FIG. 14 (a) illustrating a step of preparing a support sheet (a preparing step),
FIG. 14 (b) illustrating a step of disposing reflecting layers on the support sheet (a disposing step),
FIG. 14 (c) illustrating a step of disposing LEDs on the support sheet so that the lower surfaces of the LEDs are covered with the reflecting layers (a reflecting layer covering step),
FIG. 14 (d) illustrating a step of embedding the LEDs by embedding portions of an embedding-reflector sheet (a sheet disposing step),
FIG. 14 (e) illustrating a step of encapsulating the LEDs by the embedding portions (an encapsulating step) and a step of cutting a reflector portion (a cutting step),
FIG. 14 (f) illustrating a step of peeling reflecting layer-phosphor sheet-covered LEDs each including the reflector portion from the support sheet (a peeling step), and
FIG. 14 (g) illustrating a step of mounting the reflecting layer-phosphor sheet-covered LED including the reflector portion on a board (a mounting step).

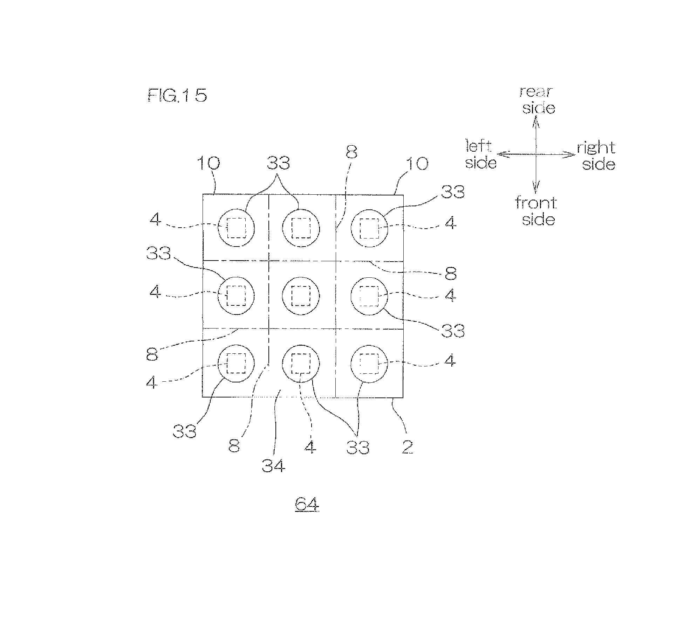

FIG. 15 shows a plan view of the phosphor sheet-embedded LEDs shown in FIG. 14 (e).

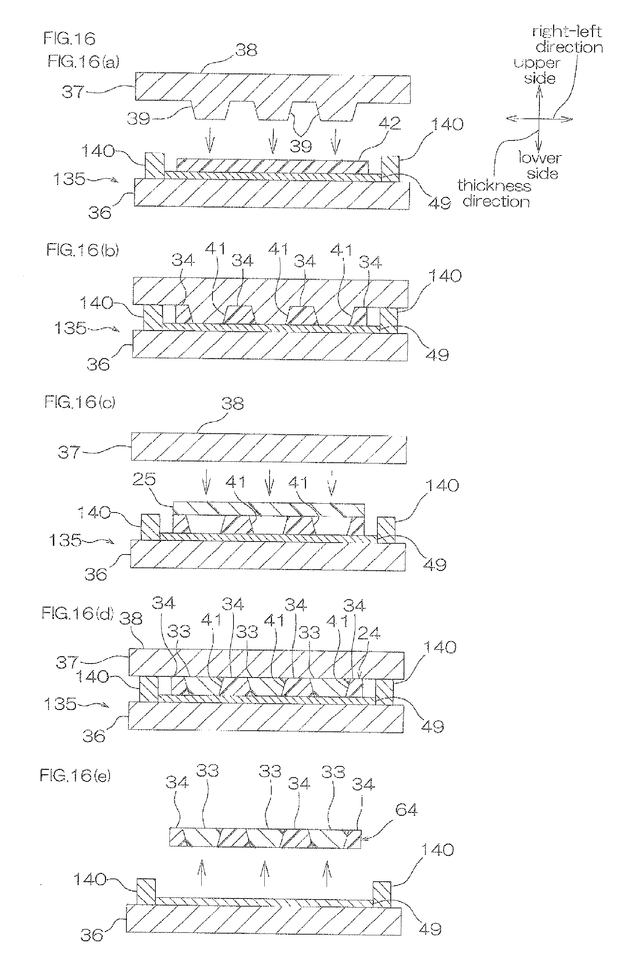

FIG. 16 shows process drawings for illustrating a method for producing the embedding-reflector sheet shown in FIG. 14 (c):
FIG. 16 (a) illustrating a step of disposing a reflector sheet on a pressing device,
FIG. 16 (b) illustrating a step of pressing the reflector sheet to form a reflector portion,
FIG. 16 (c) illustrating a step of disposing a phosphor sheet on the reflector portion,
FIG. 16 (d) illustrating a step of pressing the phosphor sheet to form embedding portions, and
FIG. 16 (e) illustrating a step of peeling the embedding-reflector sheet from a releasing sheet.

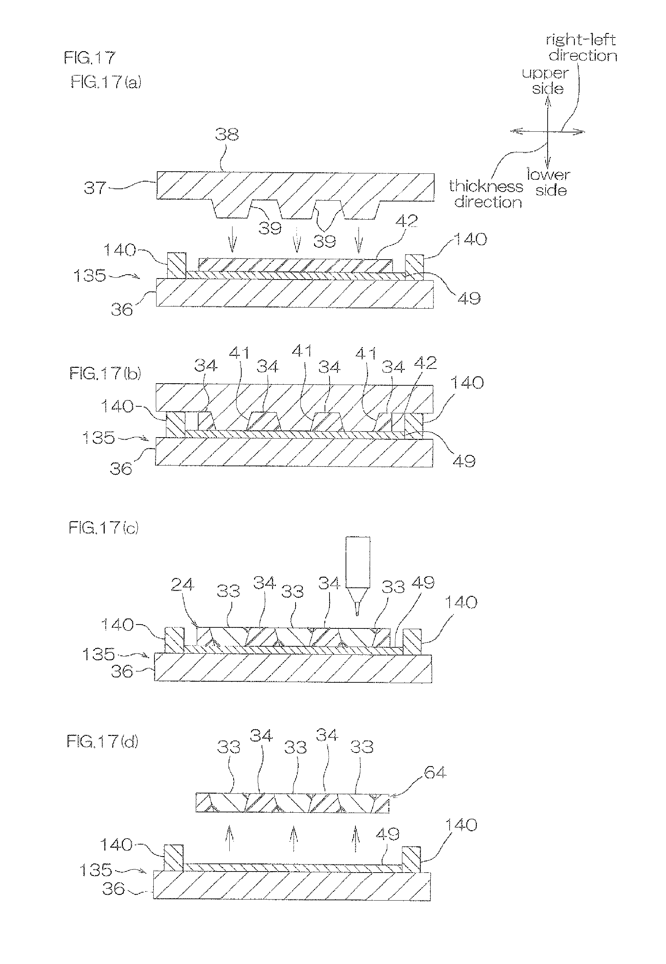

FIG. 17 shows process drawings for illustrating a method for producing an embedding-reflector sheet used in a twelfth embodiment of a method for producing a reflecting layer-phosphor layer-covered LED of the present invention:
FIG. 17 (a) illustrating a step of disposing a reflector sheet on a pressing device,
FIG. 17 (b) illustrating a step of pressing the reflector sheet to form a reflector portion,
FIG. 17 (c) illustrating a step of potting a varnish of a phosphor resin composition into through holes, and
FIG. 17 (d) illustrating a step of peeling the embedding-reflector sheet from a releasing sheet.

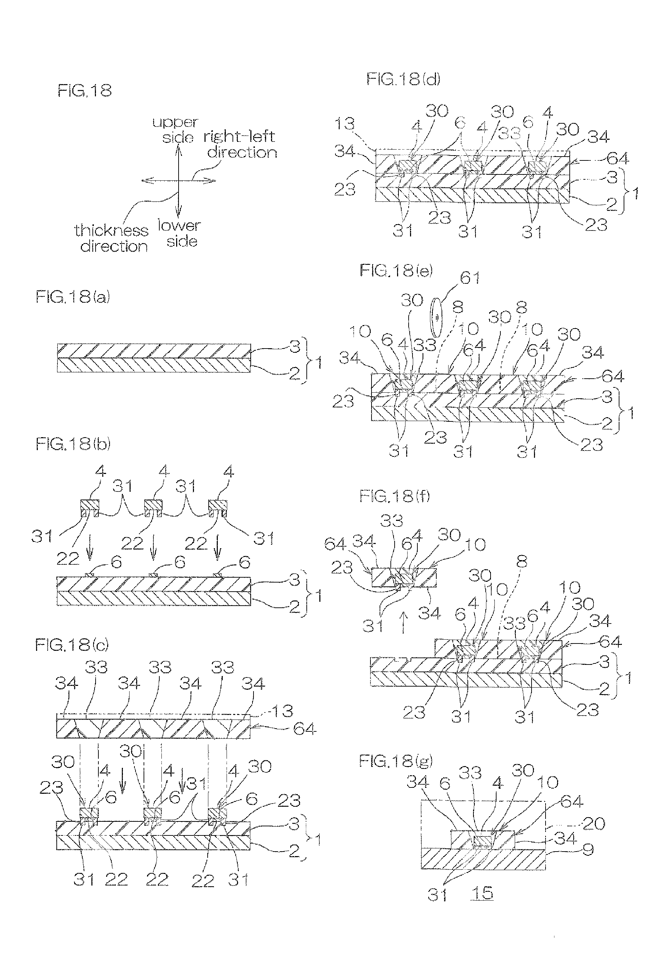

FIG. 18 shows process drawings for illustrating a thirteenth embodiment of a method for producing a reflecting layer-phosphor layer-covered LED of the present invention:
FIG. 18 (a) illustrating a step of preparing a support sheet (a preparing step),
FIG. 18 (b) illustrating a step of disposing reflecting layers on the support sheet (a disposing step),
FIG. 18 (c) illustrating a step of disposing LEDs on the support sheet so that the lower surfaces of the LEDs are covered with the reflecting layers (a reflecting layer covering step),
FIG. 18 (d) illustrating a step of embedding the LEDs by embedding portions of an embedding-reflector sheet (a sheet disposing step),
FIG. 18 (e) illustrating a step of encapsulating the LEDs by the embedding portions (an encapsulating step) and a step of cutting a reflector portion (a cutting step),
FIG. 18 (f) illustrating a step of peeling reflecting layer-phosphor sheet-covered LEDs each including the reflector portion from the support sheet (a peeling step), and
FIG. 18 (g) illustrating a step of mounting the reflecting layer-phosphor sheet-covered LED including the reflector portion on a board (a mounting step).

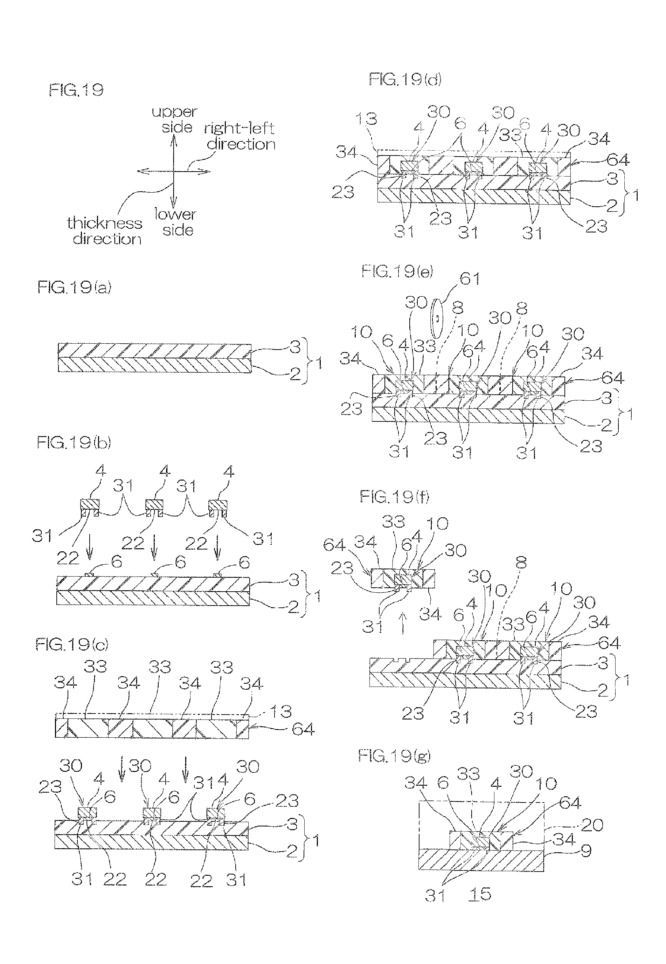

FIG. 19 shows process drawings for illustrating a fourteenth embodiment of a method for producing a reflecting layer-phosphor layer-covered LED of the present invention:
FIG. 19 (a) illustrating a step of preparing a support sheet (a preparing step),
FIG. 19 (b) illustrating a step of disposing reflecting layers on the support sheet (a disposing step),
FIG. 19 (c) illustrating a step of disposing LEDs on the support sheet so that the lower surfaces of the LEDs are covered with the reflecting layers (a reflecting layer covering step),
FIG. 19 (d) illustrating a step of embedding the LEDs by embedding portions of an embedding-reflector sheet (a phosphor sheet covering step),
FIG. 19 (e) illustrating a step of encapsulating the LEDs by the embedding portions (an encapsulating step) and a step of cutting a reflector portion (a cutting step),
FIG. 19 (f) illustrating a step of peeling reflecting layer-phosphor sheet-covered LEDs each including the reflector portion from the support sheet (a peeling step), and
FIG. 19 (g) illustrating a step of mounting the reflecting layer-phosphor sheet-covered LED including the reflector portion on a board (a mounting step).

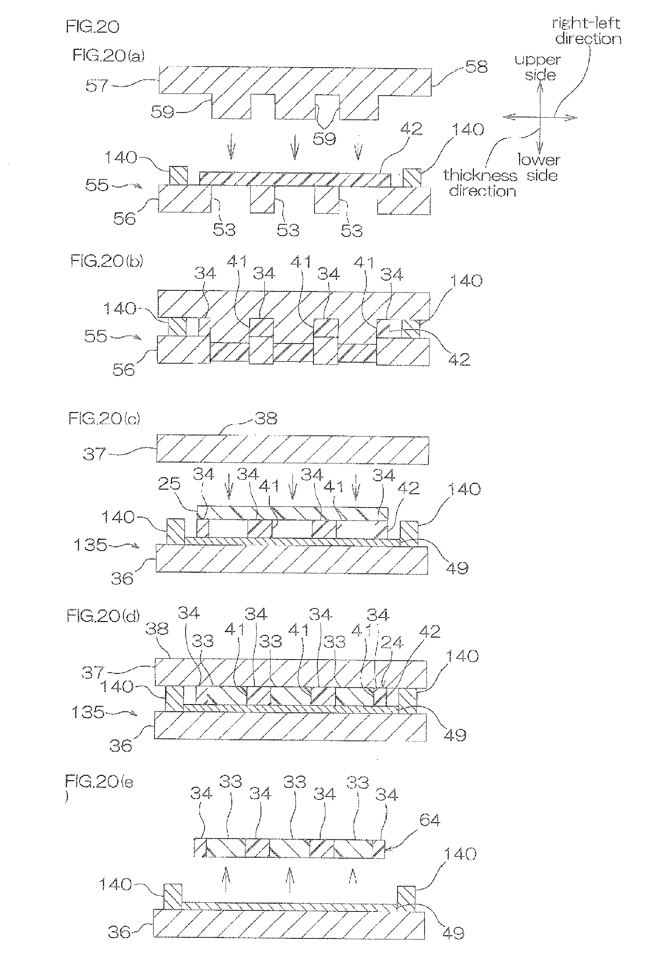

FIG. 20 shows process drawings for illustrating a method for producing the embedding-reflector sheet shown in FIG. 19 (c):
FIG. 20 (a) illustrating a step of disposing a reflector sheet on a punching device,
FIG. 20 (b) illustrating a step of stamping out the reflector sheet to form a reflector portion,
FIG. 20 (c) illustrating a step of disposing a phosphor sheet on the reflector portion,
FIG. 20 (d) illustrating a step of pressing the phosphor sheet to form embedding portions, and
FIG. 20 (e) illustrating a step of peeling the embedding-reflector sheet from a releasing sheet.

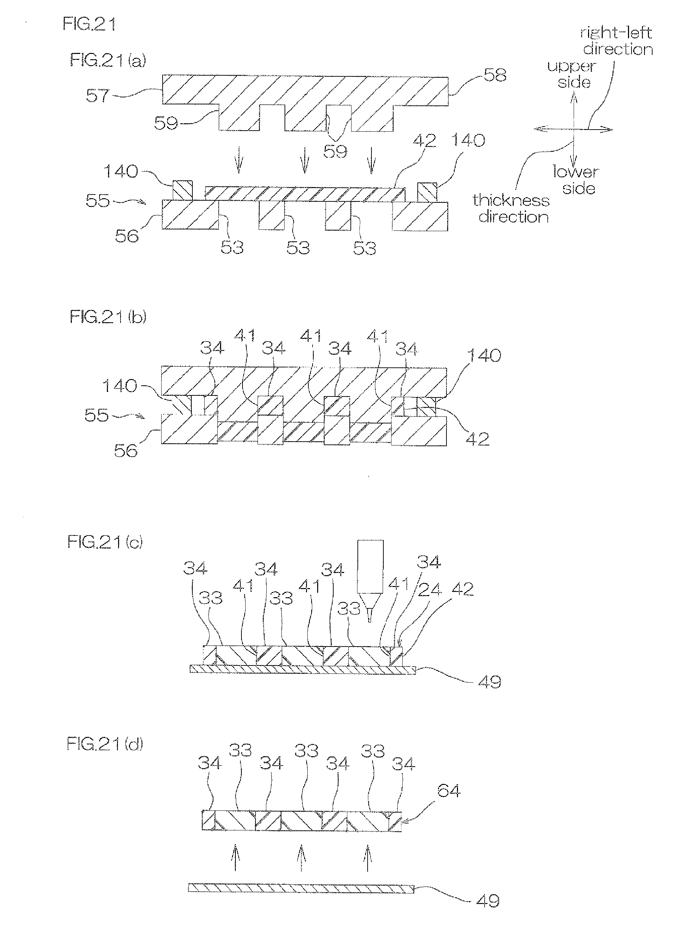

FIG. 21 shows process drawings for illustrating a method for producing an embedding-reflector sheet used in a fifteenth embodiment of a method for producing a reflecting layer-phosphor layer-covered LED of the present invention:
FIG. 21 (a) illustrating a step of disposing a reflector sheet on a punching device,
FIG. 21 (b) illustrating a step of stamping out the reflector sheet to form a reflector portion,
FIG. 21 (c) illustrating a step of potting a varnish of a phosphor resin composition into through holes, and
FIG. 21 (d) illustrating a step of peeling the embedding-reflector sheet from a releasing sheet.

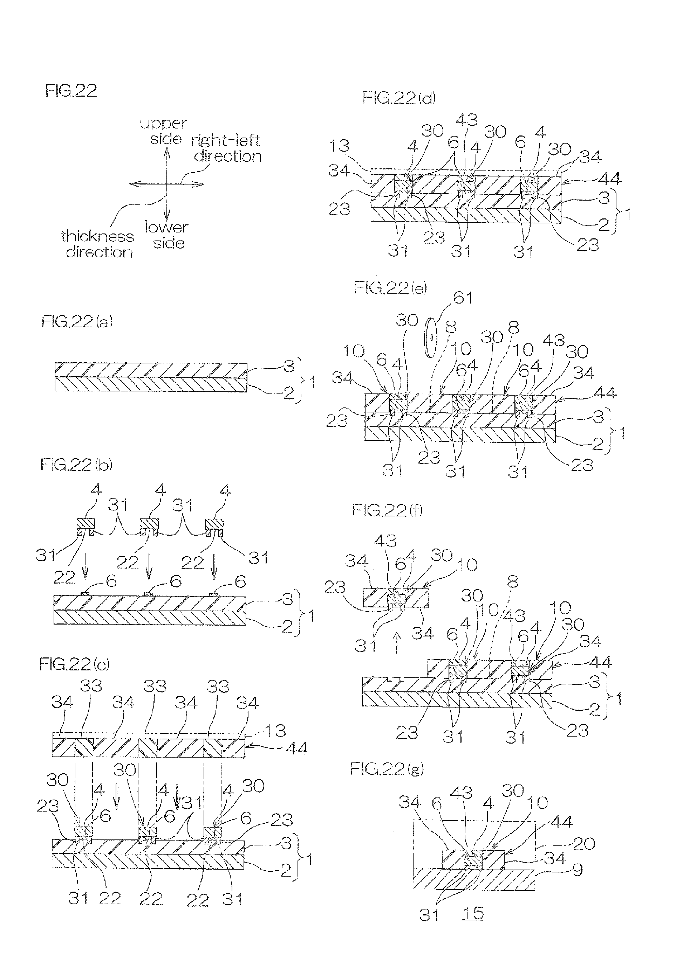

FIG. 22 shows process drawings for illustrating a sixteenth embodiment of a method for producing a reflecting layer-phosphor layer-covered LED of the present invention:
FIG. 22 (a) illustrating a step of preparing a support sheet (a preparing step),
FIG. 22 (b) illustrating a step of disposing reflecting layers on the support sheet (a disposing step),
FIG. 22 (c) illustrating a step of disposing LEDs on the support sheet so that the lower surfaces of the LEDs are covered with the reflecting layers (a reflecting layer covering step),
FIG. 22 (d) illustrating a step of covering the upper surfaces of the LEDs with cover portions of a cover-reflector sheet (a phosphor sheet covering step),
FIG. 22 (e) illustrating a step of curing the cover portions of the cover-reflector sheet (a curing step) and a step of cutting a reflector portion (a cutting step),
FIG. 22 (f) illustrating a step of peeling reflecting layer-phosphor sheet-covered LEDs each including the reflector portion from the support sheet (a peeling step), and
FIG. 22 (g) illustrating a step of mounting the reflecting layer-phosphor sheet-covered LED including the reflector portion on a board (a mounting step).

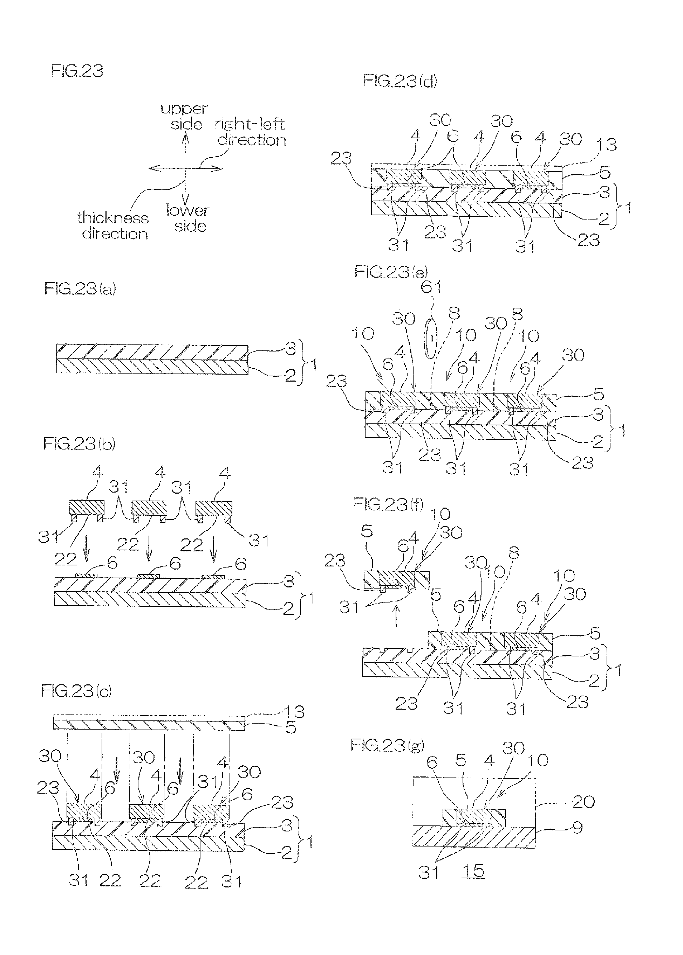

FIG. 23 shows process drawings for illustrating a seventeenth embodiment of a method for producing a reflecting layer-phosphor layer-covered LED of the present invention:
FIG. 23 (a) illustrating a step of preparing a support sheet (a preparing step),
FIG. 23 (b) illustrating a step of disposing reflecting layers on the support sheet (a disposing step),
FIG. 23 (c) illustrating a step of disposing LEDs on the support sheet so that the lower surfaces of the LEDs are covered with the reflecting layers (a reflecting layer covering step),
FIG. 23 (d) illustrating a step of covering the side surfaces of the LEDs with a phosphor sheet (a phosphor sheet covering step),
FIG. 23 (e) illustrating a step of encapsulating the LEDs by the phosphor sheet (an encapsulating step) and a step of cutting a reflector portion (a cutting step),
FIG. 23 (f) illustrating a step of peeling reflecting layer-phosphor sheet-covered LEDs each including the reflector portion from the support sheet (a peeling step), and
FIG. 23 (g) illustrating a step of mounting the reflecting layer-phosphor sheet-covered LED including the reflector portion on a board (a mounting step).

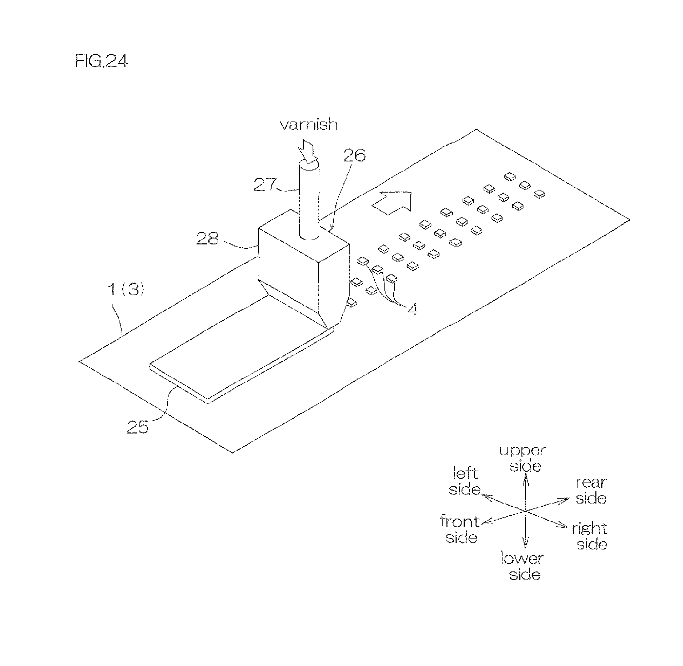

FIG. 24 shows a perspective view of a dispenser used in an eighteenth embodiment of a method for producing a reflecting layer-phosphor layer-covered LED of the present invention.

### DETAILED DESCRIPTION OF THE INVENTION

<First Embodiment>

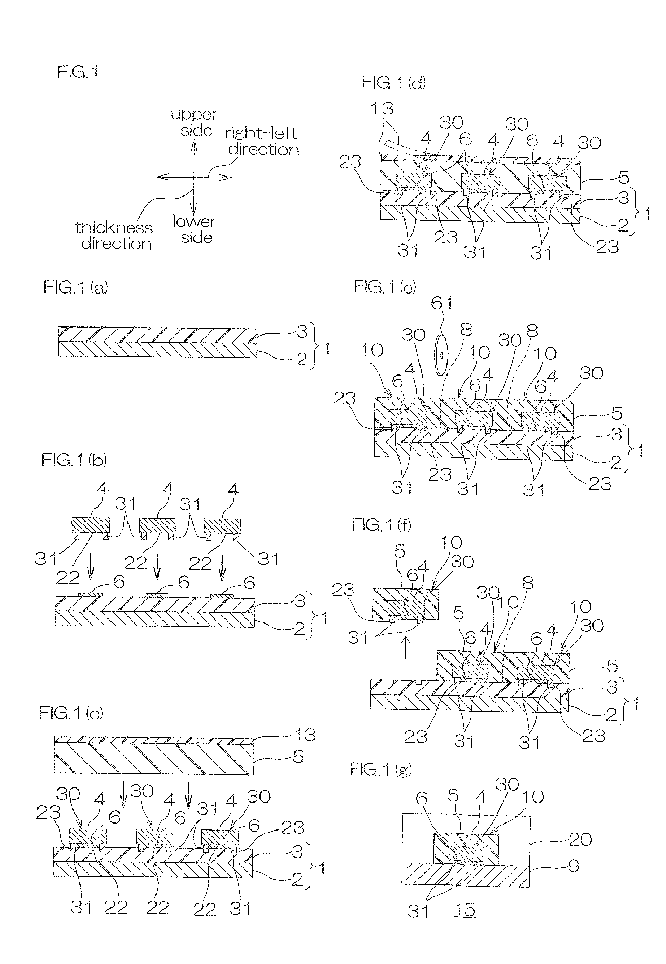

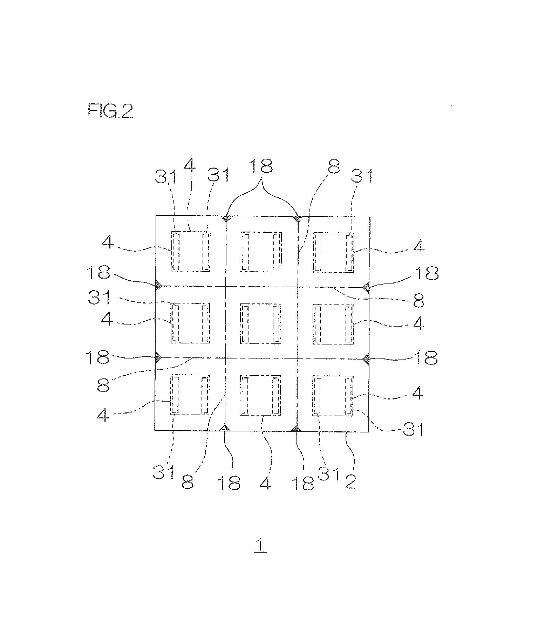

In FIG. 1, the up-down direction of the paper surface is referred to as an up-down direction (a first direction, a thickness direction); the right-left direction of the paper surface is referred to as a right-left direction (a second direction, a direction perpendicular to the first direction); and the paper thickness direction of the paper is referred to as a front-rear direction (a third direction, a direction perpendicular to the first direction and the second direction). Directions and direction arrows in FIG. 2 and the subsequent figures are in conformity with the above-described directions and the direction arrows in FIG. 1.

FIG. 1 shows process drawings for illustrating a first embodiment of a method for producing a reflecting layer-phosphor layer-covered LED of the present invention. FIG. 2 shows a plan view of the support sheet shown in FIG. 1 (a).

In FIG. 2, a pressure-sensitive adhesive layer 3 to be described later is omitted so as to clearly show the relative arrangement of a support board 2 and a reference mark 18 to be described later.

A method for producing a reflecting layer-phosphor sheet-covered LED 10 that is one example of a reflecting layer-phosphor layer-covered LED includes the steps of disposing reflecting layers (first reflecting portions) 6 on (at one side in the thickness direction of) a support sheet 1 as a support (ref: FIGS. 1 (a) and 1 (b)) (a disposing step); after the disposing step, disposing LEDs 4 provided with terminals 31 on the lower surfaces (one surfaces) thereof on (at one side in the thickness direction of) the support sheet 1 so that the lower surfaces (one surfaces) of the LEDs 4 are covered with the reflecting layers 6 (ref: FIG. 1 (c)) (a reflecting layer covering step); after the reflecting layer covering step, forming a phosphor sheet 5 so as to cover the upper surfaces (the other surfaces) and the side surfaces of the LEDs 4 (one example of a phosphor layer covering step, ref: FIGS. 1 (d) and 1 (e)) (a phosphor sheet covering step); and after the phosphor sheet covering step, peeling the reflecting layer-phosphor sheet-covered LEDs 10 from the support sheet 1 (ref: FIG. 1 (f)) (a peeling step).

In the following, the steps of the first embodiment are described in detail.

[Disposing Step]

In the disposing step, first, the support sheet 1 is prepared.

As shown in FIGS. 1 (a) and 2, the support sheet 1 is formed into a sheet shape extending in the plane direction (a direction perpendicular to the thickness direction, that is, the right-left direction and the front-rear direction). The support sheet 1 is formed into, for example, a rectangular shape in plane view (a shape when projected in the thickness direction).

The support sheet 1 is prepared so that the reference marks 18, which serve as a reference of cutting in a cutting step (ref: dashed lines in FIG. 1 (e)) to be described later, are provided in advance.

As shown in FIG. 2, a plurality of the reference marks 18 are provided at spaced intervals to each other at the circumference end portion in the plane direction of the support sheet 1. The reference marks 18 are, for example, provided at two sides that are opposed to each other in the support sheet 1. The reference marks 18 are formed to make a pair opposing to each other in an opposing direction of the two sides of the support sheet 1. One pair of the reference marks 18 is provided corresponding to the LEDs 4 that are subsequently disposed and is disposed so as to be capable of singulating the LEDs 4 when the phosphor sheet 5 is cut with the reference marks 18 as a reference.

Each of the reference marks 18 is formed into a shape that is easily recognized in plane view and is, for example, formed into a generally triangular shape in plane view.

In a size of the support sheet 1, the maximum length thereof is, for example, 10 mm or more and 300 mm or less.

The support sheet 1 is configured to be capable of supporting the LEDs 4 (ref: FIG. 1 (b)) to be described next and as shown in FIGS. 1 (a) and 2, includes, for example, the support board 2 and the pressure-sensitive adhesive layer 3 that is laminated on the upper surface of the support board 2.

The support board 2 is formed into a plate shape extending in the plane direction. The support board 2 is provided in the lower portion of the support sheet 1 and is formed to have the generally same shape as that of the support sheet 1 in plane view.

In the upper portion of the support board 2, the reference marks 18 are formed. The reference marks 18 are, in sectional view, though not shown, formed as concave portions that dent from the upper surface toward the middle in the up-down direction of the support board 2 or as through holes that pass through in the up-down direction thereof.

The support board 2 is formed of a hard material that is incapable of stretching in the plane direction. To be specific, examples of the material include an oxide such as a silicon oxide (silica or the like) and alumina, a metal such as stainless steel, and silicon.

The support board 2 has a Young's modulus at 23°C of, for example, 10⁶ Pa or more, preferably 10⁷ Pa or more, or more preferably 10⁸ Pa or more, and of, for example, 10¹² Pa or less. When the Young's modulus of the support board 2 is not less than the above-described lower limit, hardness of the support board 2 is secured and the LEDs 4 (ref: FIG. 1 (b)) to be described later can be further surely supported. The Young's modulus of the support board 2 is obtained by, for example, the compressive elastic modulus in JIS H 7902:2008.

The thickness of the support board 2 is, for example, 0.1 mm or more, or preferably 0.3 mm or more, and is, for example, 5 mm or less, or preferably 2 mm or less.

The pressure-sensitive adhesive layer 3 is formed on the entire upper surface of the support board 2.

An example of a pressure-sensitive adhesive material for forming the pressure-sensitive adhesive layer 3 includes a pressure-sensitive adhesive such as an acrylic pressure-sensitive adhesive and a silicone pressure-sensitive adhesive. The pressure-sensitive adhesive layer 3 can be also formed of, for example, an active energy ray irradiation release sheet in which the pressure-sensitive adhesive force is capable of being reduced by application of an active energy ray (to be specific, an active energy ray irradiation release sheet described in Japanese Unexamined Patent Publication No. 2005-286003 or the like) or a thermal release sheet in which the pressure-sensitive adhesive force is capable of being reduced by heating (to be specific, a thermal release sheet such as REVALPHA (manufactured by NITTO DENKO CORPORATION)). To be specific, when a phosphor resin composition in the phosphor sheet 5 (ref: the upper portion in FIG. 1 (c)) to be described later contains a thermosetting resin, preferably, the pressure-sensitive adhesive layer 3 is formed of an active energy ray irradiation release sheet. On the other hand, when a phosphor resin composition in the phosphor sheet 5 to be described later contains an active energy ray curable resin, preferably, the pressure-sensitive adhesive layer 3 is formed of a thermal release sheet.

The thickness of the pressure-sensitive adhesive layer 3 is, for example, 0.1 mm or more, or preferably 0.2 mm or more, and is, for example, 1 mm or less, or preferably 0.5 mm or less.

In order to prepare the support sheet 1, for example, the support board 2 is attached to the pressure-sensitive adhesive layer 3. Also, the pressure-sensitive adhesive layer 3 can be directly laminated on the support board 2 by an application method or the like in which first, the support board 2 is prepared; next, a varnish prepared from the above-described pressure-sensitive adhesive material and a solvent blended as required is applied to the support board 2; and thereafter, the solvent is distilled off as required.

The thickness of the support sheet 1 is, for example, 0.2 mm or more, or preferably 0.5 mm or more, and is, for example, 6 mm or less, or preferably 2.5 mm or less.

Thereafter, the reflecting layers 6 are disposed on the support sheet 1.

The reflecting layers 6 are provided on the upper surface of the pressure-sensitive adhesive layer 3 in a pattern of corresponding to the lower surfaces of the LEDs 4 that are to be disposed next. To be specific, the reflecting layers 6 are provided in a region excluding a portion for the terminals 31 in a region corresponding to the lower surfaces of the LEDs 4.

In order to provide the reflecting layers 6 on the support sheet 1, for example, the following method is used: that is, a laminating method in which a reflecting sheet formed from a reflecting resin composition is laminated on the support sheet 1 or an application method in which a liquid reflecting resin composition is applied to the support sheet 1. To be specific, a casting method, a spin coating method, a roll coating method, or the like is used.

The reflecting resin composition contains, for example, a resin and a light reflecting component.

An example of the resin includes a thermosetting resin such as a thermosetting silicone resin, an epoxy resin, a thermosetting polyimide resin, a phenol resin, a urea resin, a melamine resin, an unsaturated polyester resin, a diallyl phthalate resin, and a thermosetting urethane resin. Preferably, a thermosetting silicone resin and an epoxy resin are used.

The light reflecting component is, for example, a white compound. To be specific, an example of the white compound includes a white pigment.

An example of the white pigment includes a white inorganic pigment. Examples of the white inorganic pigment include an oxide such as a titanium oxide, a zinc oxide, and a zirconium oxide; a carbonate such as white lead (lead carbonate) and calcium carbonate; and a clay mineral such as kaolin (kaolinite).

As the white inorganic pigment, preferably, an oxide is used, or more preferably, a titanium oxide is used.

To be specific, the titanium oxide is TiO₂ (titanium oxide (IV), titanium dioxide).

A crystal structure of the titanium oxide is not particularly limited. Examples of the crystal structure thereof include a rutile type, a brookite type (pyromelane), and an anatase type (octahedrite). Preferably, a rutile type is used.

A crystal system of the titanium oxide is not particularly limited. Examples of the crystal system thereof include a tetragonal system and an orthorhombic system. Preferably, a tetragonal system is used.

When the crystal structure and the crystal system of the titanium oxide are the futile type and the tetragonal system, respectively, it is possible to effectively prevent a reduction of the reflectivity with respect to light (to be specific, visible light, among all, the light around the wavelength of 450 nm) even in a case where the reflecting layers 6 are exposed to a high temperature for a long time.

The light reflecting component is in the form of a particle. The shape thereof is not limited and examples of the shape thereof include a sphere shape, a plate shape, and a needle shape. The average value of the maximum length (in the case of a sphere shape, the average particle size) of the light reflecting component is, for example, 1 nm or more and 1000 nm or less. The average value of the maximum length is measured using a laser diffraction scattering particle size analyzer.

The mixing ratio of the light reflecting component with respect to 100 parts by mass of the resin is, for example, 30 parts by mass or more, or preferably 50 parts by mass or more, and is, for example, 200 parts by mass or less, or preferably 100 parts by mass or less.

The above-described light reflecting component is uniformly dispersed and mixed in the resin.

Also, a filler can be further added to the reflecting resin composition. That is, the filler can be used in combination with the light reflecting component (to be specific, a white pigment).

An example of the filler includes a known filler excluding the above-described white pigment. To be specific, examples of the filler include organic microparticles such as silicone particles and inorganic microparticles such as silica, talc, alumina, aluminum nitride, and silicon nitride.

The addition ratio of the filler is adjusted so that the total amount of the filler and the light reflecting component with respect to 100 parts by mass of the resin is, for example, 400 parts by mass or more, preferably 500 parts by mass or more, or more preferably 600 parts by mass or more, and is, for example, 2500 parts by mass or less, preferably 2000 parts by mass or less, or more preferably 1600 parts by mass or less.

In the laminating method, the reflecting resin composition is prepared in an A-stage state by blending the above-described resin and light reflecting component, and the filler, which is added as required, to be uniformly mixed.

In the laminating method, the reflecting resin composition in an A-stage state is applied to the entire surface of a release sheet that is not shown by an application method such as a casting, a spin coating, or a roll coating and thereafter, the applied product is heated to be brought into a B-stage state to be then subjected to etching, so that a reflecting sheet is formed in the above-described pattern. Examples of the release sheet include a polymer film such as a polyethylene film and a polyester film (PET or the like), a ceramic sheet, and a metal foil. Preferably, a polymer film is used. The surface of the release sheet can be also subjected to release treatment such as fluorine treatment.

Alternatively, for example, the reflecting resin composition in an A-stage state is applied to the surface of a release sheet that is not shown by a screen printing or the like in the above-described pattern and thereafter, the applied product is heated to form a reflecting sheet in a B-stage state in the above-described pattern.

Thereafter, the reflecting sheet is transferred onto the pressure-sensitive adhesive layer 3 to obtain the reflecting layer 6 in the same pattern as that of the reflecting sheet on the upper surface of the pressure-sensitive adhesive layer 3. Subsequently, the release sheet that is not shown is peeled off

On the other hand, in the application method, the above-described reflecting resin composition in an A-stage state is applied to the upper surface of the pressure-sensitive adhesive layer 3 by a screen printing or the like in the above-described pattern and thereafter, the applied product is heated to form the reflecting layer 6 in a B-stage state in the above-described pattern.

[Reflecting Layer Covering Step]

In the reflecting layer covering step, as shown in FIG. 1 (b) and by phantom lines in FIG. 2, a plurality of the LEDs 4 are prepared to be disposed on the support sheet 1.

The LEDs 4 are semiconductor elements that convert electrical energy to light energy. Each of the LEDs 4 is, for example, formed into a generally rectangular shape in sectional view and a generally rectangular shape in plane view with the thickness shorter than the length in the plane direction (the maximum length). An example of the LEDs 4 includes blue light emitting diode elements that emit blue light.

On the lower surface of each of the LEDs 4, a plurality (two pieces) of the terminals 31 are provided. A plurality of the terminals 31 include a p-type bump and an n-type bump. A plurality of the terminals 31 are spaced in opposed relation to each other in the plane direction and are formed to extend along two sides of each of the LEDs 4 disposed in opposed relation to each other in bottom view so as to slightly protrude downwardly from the lower surface of each of the LEDs 4. The lower surfaces of the terminals 31 are formed to be disposed at the same position when projected in an opposing direction of the two pieces of the terminals 31.

The maximum length in the place direction of each of the LEDs 4 is, for example, 0.1 mm or more and 3 mm or less. The thickness thereof is, for example, 0.05 mm or more and 1 mm or less.

The length of each of the terminals 31 is, for example, 0.01 mm or more and 0.5 mm or less. The width thereof is, for example, 0.005 mm or more and 0.2 mm or less. The thickness (the height) thereof is formed to be thicker than that of each of the reflecting layers 6 and to be specific, is, for example, 0.01 mm or more, or preferably 0.05 mm or more, and is, for example, 1 mm or less, or preferably 0.5 mm or less. The base area of a plurality of the terminals 31 with respect to the base area of the LEDs 4 is, for example, 1 % or more, or preferably 5 % or more, and is, for example, 99 % or less, or preferably 90 % or less.

In the reflecting layer covering step, as shown by arrows in FIG. 1 (b), a plurality of the LEDs 4 are laminated with respect to the pressure-sensitive adhesive layer 3 and the reflecting layers 6. To be specific, of the lower surfaces of the LEDs 4, exposed surfaces (central surfaces) 22 that are exposed from the terminals 31 are allowed to adhere (pressure-sensitively adhere) to the reflecting layers 6. To be more specific, the exposed surfaces 22 of the LEDs 4 are compressively bonded to the reflecting layers 6 in a B-stage state. More particularly, the LEDs 4 are thermal compressively bonded to the reflecting layers 6 in a B-stage state. The reflecting layers 6 are cured (completely cured) by the thermal compressively bonding to be brought into a C-stage state. In this way, the reflecting layers 6 adhere to the exposed surfaces 22.

At the same time, the terminals 31 of the LEDs 4 are pressed into the pressure-sensitive adhesive layer 3 in which the reflecting layers 6 are not formed. That is, when the exposed surfaces 22 of the LEDs 4 adhere to the reflecting layers 6, the thickness of each of the terminals 31 is thicker than that of each of the reflecting layers 6, so that the lower end portions of the terminals 31 are defined as extruded portions 23 that are extruded from the reflecting layers 6 downwardly and the extruded portions 23 fall into (sink into) the pressure-sensitive adhesive layer 3 in a B-stage state. The extruded length of each of the extruded portions 23 is obtained by subtracting the thickness of each of the reflecting layers 6 from that of each of the terminals 31 and is adjusted to be thinner than the thickness of the pressure-sensitive adhesive layer 3.

In this way, the exposed surfaces 22 are covered with the reflecting layers 6.

In this way, reflecting layer-covered LEDs 30, each of which includes the LED 4 and the reflecting layer 6 that is formed so as to cover the exposed surface 22 on the lower surface thereof, are obtained in a state of being in close contact with the pressure-sensitive adhesive layer 3.

[Phosphor Sheet Covering Step]

The phosphor sheet covering step is performed after the reflecting layer covering step.

In the phosphor sheet covering step, the phosphor sheet 5 is formed so as to cover the upper surfaces and the side surfaces of the LEDs 4 to produce the reflecting layer-phosphor sheet-covered LEDs 10. The phosphor sheet covering step includes the steps of disposing the phosphor sheet 5 on (at one side in the thickness direction of) the support sheet 1 (one example of the layer disposing step, ref: FIG. 1 (d)) (a sheet disposing step), curing the phosphor sheet 5 to encapsulate the LEDs 4 by the phosphor sheet 5 (ref: FIG. 1 (e)) (an encapsulating step), and after the encapsulating step, cutting the phosphor sheet 5 corresponding to each of the LEDs 4 (ref: the dashed lines in FIG. 1 (e)) (a cutting step).

[Sheet Disposing Step]

In FIG. 1 (c), the phosphor sheet 5 is formed from a phosphor resin composition containing a curable resin and a phosphor into a sheet shape.

Examples of the curable resin include a thermosetting resin that is cured by heating and an active energy ray curable resin that is cured by application of an active energy ray (for example, an ultraviolet ray and an electron beam). Preferably, a thermosetting resin is used.

To be specific, an example of the curable resin includes a thermosetting resin such as a silicone resin, an epoxy resin, a polyimide resin, a phenol resin, a urea resin, a melamine resin, and an unsaturated polyester resin. Preferably, a silicone resin is used.

An example of the silicone resin includes a silicone resin such as a two-step curable type silicone resin and a one-step curable type silicone resin. Preferably, a two-step curable type silicone resin is used.

The two-step curable type silicone resin is a thermosetting silicone resin that has a two-step reaction mechanism and in which a silicone resin is bought into a B-stage state (a semi-cured state) in the first-step reaction and is brought into a C-stage state (a final cured state) in the second-step reaction. On the other hand, the one-step curable type silicone resin is a thermosetting silicone resin that has a one-step reaction mechanism and in which a silicone resin is subjected to a final curing in the first-step reaction.

The B-stage state is a state between an A-stage state in which a thermosetting silicone resin is in a liquid state and a C-stage state in which the thermosetting silicone resin is completely cured. Also, the B-stage state is a state in which the curing and the gelation of the thermosetting silicone resin are slightly progressed and the compressive elastic modulus thereof is smaller than the elastic modulus thereof in a C-stage state.

An example of the two-step curable type silicone resin includes a condensation reaction and addition reaction curable type silicone resin that has two reaction systems of a condensation reaction and an addition reaction.

The mixing ratio of the curable resin with respect to the phosphor resin composition is, for example, 30 mass % or more, or preferably 50 mass % or more, and is, for example, 99 mass % or less, or preferably 95 mass % or less.

The phosphor has a wavelength conversion function and examples thereof include a yellow phosphor that is capable of converting blue light into yellow light and a red phosphor that is capable of converting blue light into red light.

Examples of the yellow phosphor include a garnet type phosphor having a garnet type crystal structure such as Y₃Al₅O₁₂:Ce (YAG (yttrium aluminum garnet):Ce) and Tb₃Al₃O₁₂:Ce (TAG (terbium aluminum garnet):Ce) and an oxynitride phosphor such as Ca-α-SiAlON.

An example of the red phosphor includes a nitride phosphor such as CaAlSiN₃:Eu and CaSiN₂:Eu.

Preferably, a yellow phosphor is used.

Examples of a shape of the phosphor include a sphere shape, a plate shape, and a needle shape. Preferably, in view of fluidity, a sphere shape is used.

The average value of the maximum length (in the case of a sphere shape, the average particle size) of the phosphor is, for example, 0.1 µm or more, or preferably 1 µm or more, and is, for example, 200 µm or less, or preferably 100 µm or less.

The mixing ratio of the phosphor with respect to 100 parts by mass of the curable resin is, for example, 0.1 parts by mass or more, or preferably 0.5 parts by mass or more, and is, for example, 80 parts by mass or less, or preferably 50 parts by mass or less.

Furthermore, the phosphor resin composition can also contain a filler. An example of the filler includes that illustrated in the reflecting resin composition. The mixing ratio of the filler with respect to 100 parts by mass of the curable resin is, for example, 0. 1 parts by mass or more, or preferably 0.5 parts by mass or more, and is, for example, 70 parts by mass or less, or preferably 50 parts by mass or less.

As shown in FIG. 1 (d), in order to dispose the phosphor sheet 5 on the support sheet 1, first, as shown by the upper portion in FIG. 1 (c), the phosphor sheet 5 is prepared. In order to prepare the phosphor sheet 5, a curable resin and a phosphor, and a filler, which is blended as required, are blended to prepare a phosphor resin composition. Next, the phosphor resin composition is applied to the surface of a release sheet 13 to be then heated.

When the curable resin contains a two-step curable type silicone resin, the curable resin is brought into a B-stage state (a semi-cured state) by the above-described heating. That is, the phosphor sheet 5 in a B-stage state is prepared.

The phosphor sheet 5 has a compressive elastic modulus at 23°C of, for example, 0.01 MPa or more, or preferably 0.04 MPa or more, and of, for example, 1.0 MPa or less, or preferably 0.2 MPa or less.

When the compressive elastic modulus of the phosphor sheet 5 is not more than the above-described upper limit, sufficient flexibility can be secured. On the other hand, when the compressive elastic modulus of the phosphor sheet 5 is not less than the above-described lower limit, the reflecting layer-covered LEDs 30 can be embedded.

Next, as shown in FIG. 1 (d), the phosphor sheet 5 is disposed on the support sheet 1 so as to embed the reflecting layer-covered LEDs 30.

To be specific, as shown by the arrows in FIG. 1 (c), the phosphor sheet 5 laminated on the release sheet 13 is compressively bonded toward the pressure-sensitive adhesive layer 3.

Thereafter, as shown by the phantom lines in FIG. 1 (d), the release sheet 13 is peeled from the upper surface of the phosphor sheet 5.

[Encapsulating Step]

The encapsulating step is performed after the sheet disposing step (ref: FIG. 1 (d)).

In the encapsulating step, as shown in FIG. 1 (e), the phosphor sheet 5 is cured. When the curable resin is a thermosetting resin, the phosphor sheet 5 is thermally cured. To be specific, the phosphor sheet 5 is heated at, for example, 80°C or more, or preferably 100°C or more, and at, for example, 200°C or less, or preferably 180°C or less.

When the thermosetting resin contains a two-step curable type silicone resin and when the phosphor sheet 5 that embeds the reflecting layer-covered LEDs 30 is in a B-stage state, the phosphor sheet 5 is completely cured (subjected to a final curing) to be brought into a C-stage state by the above-described heating.

When the thermosetting resin contains a one-step curable type silicone resin, the phosphor sheet 5 is completely cured (subjected to a final curing) to be brought into a C-stage state by the above-described heating.

When the curable resin is an active energy ray curable resin, an active energy ray is applied to the phosphor sheet 5.

The cured (completely cured) phosphor sheet 5 has flexibility. To be specific, the cured (completely cured) phosphor sheet 5 has a compressive elastic modulus at 23°C of, for example, 0.5 MPa or more, or preferably 1.0 MPa or more, and of, for example, 100 MPa or less, or preferably 10 MPa or less.

When the compressive elastic modulus of the phosphor sheet 5 is not more than the above-described upper limit, the flexibility can be surely secured and in the cutting step (ref: FIG. 1 (e)) to be described next, for example, the phosphor sheet 5 can be cut using a cutting device (described later). When the compressive elastic modulus of the phosphor sheet 5 is not less than the above-described lower limit, the shape thereof after being cut can be retained.

When the light transmittance of the phosphor sheet 5 is not less than the above-described lower limit, the light transmission properties can be surely secured and an LED device 15 (described later) having excellent brightness can be obtained.

By the sheet disposing step and the encapsulating step, the side surfaces (the continuous surfaces that are continuous to the upper surfaces and the lower surfaces) and the upper surfaces of the LEDs 4 in the reflecting layer-covered LEDs 30, and a portion of the upper surface of the pressure-sensitive adhesive layer 3 that is exposed from the reflecting layer-covered LEDs 30 are covered with the phosphor sheet 5 in close contact with each other. That is, the reflecting layer-covered LEDs 30 are encapsulated by the phosphor sheet 5 in a C-stage state.

[Cutting Step]

As shown by the dashed lines in FIG. 1 (e), in the cutting step, the flexible phosphor sheet 5 around the LEDs 4 is cut along the thickness direction. As shown by dash-dot lines in FIG. 2, for example, the phosphor sheet 5 is cut into a generally rectangular shape in plane view that surrounds each of the LEDs 4.

In order to cut the phosphor sheet 5, for example, a dicing device using a disc-shaped dicing saw (dicing blade) 61, a cutting device using a cutter, a laser irradiation device, or the like is used.

The cutting of the phosphor sheet 5 is performed with the reference marks 18 as a reference. To be specific, the phosphor sheet 5 is cut so as to form cuts 8 along the straight lines (shown by the dash-dot lines in FIG. 2) that connect the reference marks 18 making one pair.

In the cutting of the phosphor sheet 5, for example, the phosphor sheet 5 is cut from the upper surface toward the lower surface so that the cuts 8 fail to pass through the support sheet 1, to be specific, fail to pass through the pressure-sensitive adhesive layer 3.

By the cutting step, the reflecting layer-phosphor sheet-covered LEDs 10, each of which includes the reflecting layer-covered LED 30 and the phosphor sheet 5 that covers the reflecting layer-covered LED 30, are obtained in a state of being in close contact with the support sheet 1.

That is, the reflecting layer-phosphor sheet-covered LED 10 includes the LED 4, the reflecting layer 6 that is formed so as to cover the lower surface of the LED 4, and the phosphor sheet 5 that is formed so as to continuously cover the upper surface and the side surfaces of the LED 4. Furthermore, at the lower portion of the reflecting layer-phosphor sheet-covered LED 10, the terminals 31, each of which is formed with the extruded portions 23 that are extruded from the reflecting layer 6 downwardly, are provided.

[Peeling Step]

In FIG. 1 (f), in the peeling step, each of the LEDs 4, to be specific, each of the reflecting layer-phosphor sheet-covered LEDs 10 is peeled from the upper surface of the pressure-sensitive adhesive layer 3. That is, each of the reflecting layer-phosphor sheet-covered LEDs 10 is peeled from the support board 2 and the pressure-sensitive adhesive layer 3 so that interfacial peeling between the extruded portions 23 of the terminals 31 and the pressure-sensitive adhesive layer 3, and interfacial peeling between the reflecting layers 6 and the pressure-sensitive adhesive layer 3 occur.

To be specific, when the pressure-sensitive adhesive layer 3 is formed of an active energy ray irradiation release sheet, an active energy ray is applied to the pressure-sensitive adhesive layer 3. Alternatively, when the pressure-sensitive adhesive layer 3 is formed of a thermal release sheet, the pressure-sensitive adhesive layer 3 is heated.

The reflecting layer-phosphor sheet-covered LED 10 that is peeled from the support sheet 1 is obtained by those treatments.

[Mounting Step]

Thereafter, after the reflecting layer-phosphor sheet-covered LED 10 is selected in accordance with emission wavelength and luminous efficiency, as shown in FIG. 1 (g), the selected reflecting layer-phosphor sheet-covered LED 10 is mounted on a board 9. In this way, the LED device 15 is obtained.

To be specific, the terminals 31 of the reflecting layer-phosphor sheet-covered LED 10 are disposed in opposed relation to the board 9 so that a bump (not shown) in the LED 4 is opposed to a terminal (not shown) provided on the upper surface of the board 9. That is, the LED 4 in the reflecting layer-phosphor sheet-covered LED 10 is flip-chip mounted on the board 9.

In the flip-chip mounting, the terminals 31 are attempted to be electrically connected to the terminal on the board 9 and are pressed in the up-down direction, so that the extruded portions 23 are substantially destroyed to disappear. In this way, the lower surface of the reflecting layer-phosphor sheet-covered LED 10 is brought into close contact with the upper surface of the board 9.

In this way, the LED device 15 including the board 9 and the reflecting layer-phosphor sheet-covered LED 10 that is mounted on the board 9 is obtained.

Thereafter, as shown by the phantom line in FIG. 1 (g), an encapsulating protective layer 20 that encapsulates the reflecting layer-phosphor sheet-covered LED 10 is provided in the LED device 15 as required. In this way, reliability of the LED device 15 can be improved.

According to this method, the LED 4 provided with the terminals 31 on the lower surface thereof is disposed on the support sheet 1 so that the lower surface of the LED 4 is covered with the reflecting layer 6 and thereafter, the phosphor sheet 5 is formed so as to cover the upper surface and the side surfaces of the LED 4. Thus, in the reflecting layer-phosphor sheet-covered LED 10 to be obtained, the reflecting layer 6 is formed on the lower surface of the LED 4 and the phosphor sheet 5 is formed on the upper surface and the side surfaces of the LED 4.

Thus, in the LED device 15 obtained by mounting the reflecting layer-phosphor sheet-covered LED 10 on the board 9 via the terminals 31, light applied upwardly and laterally of the LED 4 transmits through the phosphor sheet 5 and the wavelength thereof is converted by the phosphor sheet 5. On the other hand, light applied downwardly of the LED 4 is reflected by the reflecting layer 6 and goes upwardly or laterally. That is, it is prevented that the light is applied from the LED 4 toward the board 9 to be absorbed in the board 9, and the amount of light going from the LED 4 upwardly and laterally can be increased.

On the other hand, in the LED device described in Japanese Unexamined Patent Publication No. 2012-39013, the light applied to the back side of the LED is absorbed in the board because the back surface of the LED is directly in contact with the board.

In contrast, the LED device 15 in the first embodiment has excellent luminous efficiency, as described above, by the reflection of light by the reflecting layer 6.

Furthermore, in the method for producing the reflecting layer-phosphor sheet-covered LED 10, after the cutting step, each of the reflecting layer-phosphor sheet-covered LEDs 10 is peeled from the support sheet 1. That is, in the cutting step, the phosphor sheet 5 is capable of being cut, while the reflecting layer-covered LEDs 30 and the phosphor sheet 5 are supported by the support sheet 1 including the hard support board 2. Thus, the reflecting layer-phosphor sheet-covered LED 10 having excellent size stability can be obtained.

After the encapsulating step in which the phosphor sheet 5 is cured, the cutting step in which the phosphor sheet 5 is cut is performed, so that a dimensional deviation caused by shrinkage of the phosphor sheet 5 that may occur in the curing can be cancelled in the cutting step. Thus, the reflecting layer-phosphor sheet-covered LED 10 having further excellent size stability can be obtained.

In addition, the phosphor sheet 5 that encapsulates the reflecting layer-covered LEDs 30 is flexible, so that in the cutting step, the phosphor sheet 5 is capable of being smoothly cut not only using an expensive dicing device, but also using various cutting devices including a relatively cheap cutting device.

In addition, in the sheet disposing step in this method, the reflecting layer-covered LEDs 30 are embedded by the phosphor sheet 5 in a B-stage state; in the encapsulating step, the phosphor sheet 5 is cured to be brought into a C-stage state; and the phosphor sheet 5 in a C-stage state encapsulates the reflecting layer-covered LEDs 30. Thus, the reflecting layer-covered LEDs 30 are easily and surely covered with the phosphor sheet 5 in a B-stage state and the phosphor sheet 5 in a C-stage state is capable of surely encapsulating the reflecting layer-covered LEDs 30.

Consequently, the reflecting layer-phosphor sheet-covered LED 10 has excellent size stability.

Also, the LED device 15 includes the reflecting layer-phosphor sheet-covered LED 10 having excellent size stability, so that it has excellent reliability and therefore, its luminous efficiency is improved.

In the disposing step in the first embodiment (ref: FIG. 1 (a)), the support sheet 1 is prepared so as to include the support board 2 and the pressure-sensitive adhesive layer 3. Alternatively, for example, though not shown, the support sheet 1 can be also prepared so as to include the support board 2 only without including the pressure-sensitive adhesive layer 3.

Preferably, as shown in FIG. 1 (a), the support sheet 1 is prepared so as to include the support board 2 and the pressure-sensitive adhesive layer 3.

In this way, in the reflecting layer covering step shown in FIG. 1 (b), when the LEDs 4 are disposed on the support sheet 1 and the reflecting layers 6, the LEDs 4 can adhere to the support board 2 via the pressure-sensitive adhesive layer 3. Thus, the support sheet 1 can surely support the LEDs 4.

In the disposing step in this method, the support sheet 1 is prepared so that the reference marks 18, which serve as a reference of cutting in the cutting step, are provided in advance.

In the cutting step, the LEDs 4 are supported by the support sheet 1, so that in this way, the LEDs 4 can be singulated with excellent accuracy with the reference marks 18 as a reference.

In FIG. 2, each of the reference marks 18 is formed into a generally triangular shape in plane view. However, the shape thereof is not particularly limited and can be formed into an appropriate shape such as a generally circular shape in plane view, a generally rectangular shape in plane view, a generally X-shape in plane view, and a generally T-shape in plane view.

<Second Embodiment>

FIG. 3 shows process drawings for illustrating a second embodiment of a method for producing a reflecting layer-phosphor layer covered LED of the present invention.

In FIG. 3, the same reference numerals are provided for members and steps corresponding to each of those in the first embodiment, and their detailed description is omitted.

In the peeling step (ref: FIG. 1 (f)) in the first embodiment, each of the reflecting layer-phosphor sheet-covered LEDs 10 is peeled from the support board 2 and the pressure-sensitive adhesive layer 3. Alternatively, for example, as shown in FIG. 3 (f), first, the support board 2 is peeled from the pressure-sensitive adhesive layer 3 and thereafter, as shown in FIG. 3 (g), each of the reflecting layer-phosphor sheet-covered LEDs 10 can be peeled from the pressure-sensitive adhesive layer 3 only.

That is, this method includes the same steps of disposing step (ref: FIGS. 3 (a) and 3 (b)), reflecting layer covering step (ref: FIG. 3 (c)), phosphor sheet covering step (ref: FIGS. 3 (d) and 3 (e)), and peeling step (ref: FIG. 3 (g)) as those in the first embodiment. In addition, as shown by the phantom lines in FIG. 3 (f), this method further includes a support board peeling step in which the support board 2 is peeled from the pressure-sensitive adhesive layer 3 after the cutting step (ref: FIG. 3 (e)) in the reflecting layer covering step and before the peeling step (ref: FIG. 3 (g)).

[Support Board Peeling Step]

As shown in FIG. 3 (f), in the support board peeling step, the support board 2 is peeled from the lower surface of the pressure-sensitive adhesive layer 3.

In order to peel the support board 2 from the pressure-sensitive adhesive layer 3, for example, the pressure-sensitive adhesive layer 3 is formed from a pressure-sensitive adhesive in which the pressure-sensitive adhesive force is capable of being reduced by application of an active energy ray such as an ultraviolet ray and the active energy ray is applied to the pressure-sensitive adhesive layer 3, so that the pressure-sensitive adhesive force of the pressure-sensitive adhesive layer 3 is reduced. Thereafter, the support board 2 is peeled from the pressure-sensitive adhesive layer 3.

Alternatively, the pressure-sensitive adhesive layer 3 is formed from a pressure-sensitive adhesive in which the pressure-sensitive adhesive force is capable of being reduced by heating and the pressure-sensitive adhesive layer 3 is heated, so that the pressure-sensitive adhesive force of the pressure-sensitive adhesive layer 3 is reduced. Thereafter, the support board 2 is peeled from the pressure-sensitive adhesive layer 3.

[Peeling Step]

Next, in the peeling step shown by the arrow in FIG. 3 (g), each of the reflecting layer-phosphor sheet-covered LEDs 10 is peeled from the pressure-sensitive adhesive layer 3.

To be specific, as shown in FIG. 3 (g'), for example, each of the reflecting layer-phosphor sheet-covered LEDs 10 is peeled from the pressure-sensitive adhesive layer 3 with a pick-up device 17 that is provided with a pressing member 14 such as a needle and an absorbing member 16 such as a collet. In the pick-up device 17, the pressing member 14 presses (pushes up) the pressure-sensitive adhesive layer 3 corresponding to the reflecting layer-phosphor sheet-covered LED 10 that is intended to be peeled off from the lower side thereof. In this way, the reflecting layer-phosphor sheet-covered LED 10 that is intended to be peeled off is pushed up upwardly, and the pushed-up reflecting layer-phosphor sheet-covered LED 10 is peeled from the pressure-sensitive adhesive layer 3, while being absorbed by the absorbing member 16 such as a collet.

In this way, as shown in FIG. 3 (g), each of the reflecting layer-phosphor sheet-covered LEDs 10 that is peeled from the support sheet 1 is obtained.

[Mounting Step]

Thereafter, after the reflecting layer-phosphor sheet-covered LED 10 is selected in accordance with emission wavelength and luminous efficiency, as shown in FIG. 3 (h), the selected reflecting layer-phosphor sheet-covered LED 10 is mounted on the board 9. In this way, the LED device 15 is obtained.

According to this method, in the peeling step, each of the reflecting layer-phosphor sheet-covered LEDs 10 is peeled from the pressure-sensitive adhesive layer 3, so that the reflecting layer-phosphor sheet-covered LED 10 can be easily and surely peeled from the pressure-sensitive adhesive layer 3 using the above-described pick-up device 17.

<Third Embodiment>

FIG. 4 shows process drawings for illustrating a third embodiment of a method for producing a reflecting layer-phosphor layer-covered LED of the present invention.

In FIG. 4, the same reference numerals are provided for members and steps corresponding to each of those in the first embodiment, and their detailed description is omitted.

In the peeling steps (ref: FIGS. 1 (f) and 3 (g)) in the first and the second embodiments, each of the reflecting layer-phosphor sheet-covered LEDs 10 is peeled from the support sheet 1 to be then mounted on the board 9 (ref: FIGS. 1 (g) and 3 (h)). Alternatively, for example, as shown in FIGS. 4 (f) and 4 (g), the reflecting layer-plxosphor sheet-covered LEDs 10 are sequentially transferred onto a transfer sheet 11 and a stretchable support sheet 24, and thereafter, as shown in FIG. 4 (h), each of the reflecting layer-phosphor sheet-covered LEDs 10 can be peeled from the stretchable support sheet 24.

That is, this method includes the same steps of disposing step (ref: FIGS. 4 (a) and 4 (b)), reflecting layer covering step (ref: FIG. 4 (c)), and phosphor sheet covering step (ref: FIG. 4 (d)) as those in the first embodiment and furthermore, includes the peeling step (ref: FIGS. 4 (e) to 4 (g)).

### [Peeling Step]

The peeling step includes the steps of transferring the reflecting layer-phosphor sheet-covered LEDs 10 onto the stretchable support sheet 24 (ref: FIG. 4 (g)) and peeling the reflecting layer-phosphor sheet-covered LEDs 10 from the stretchable support sheet 24, while stretching the stretchable support sheet 24 in the plane direction (ref: FIGS. 4 (h) and 4 (h')).

That is, in order to transfer the reflecting layer-phosphor sheet-covered LEDs 10 onto the stretchable support sheet 24, as shown by the arrows in FIG. 4 (e), and in FIG. 4 (f), the reflecting layer-phosphor sheet-covered LEDs 10 after the cutting step (ref: the dashed lines in FIG. 4 (e)) are transferred onto the transfer sheet 11 in advance.

The transfer sheet 11 is formed of the same material and with the same thickness as those in the stretchable support sheet 24 to be described next.

By the transfer of the reflecting layer-phosphor sheet-covered LEDs 10 onto the transfer sheet 11, the surface (the lower surface) of the phosphor sheet 5 is in contact (in close contact) with the upper surface of the transfer sheet 11, while the exposed surfaces 22 (the upper surfaces) of the LEDs 4 in which bumps that are not shown are formed are exposed from the phosphor sheet 5 around the LEDs 4.

Thereafter, as shown in FIG. 4 (g), the reflecting layer-phosphor sheet-covered LEDs 10 are transferred onto the stretchable support sheet 24.

The stretchable support sheet 24 is a stretchable pressure-sensitive adhesive sheet that is capable of stretching in the plane direction. Examples thereof include an active energy ray irradiation release sheet in which the pressure-sensitive adhesive force is capable of being reduced by application of an active energy ray (to be specific, an active energy ray irradiation release sheet described in Japanese Unexamined Patent Publication No. 2005-286003 or the like) and a thermal release sheet in which the pressure-sensitive adhesive force is capable of being reduced by heating (to be specific, a thermal release sheet such as REVALPHA (manufactured by NITTO DENKO CORPORATION)). Preferably, an active energy ray irradiation release sheet is used.

The stretchable support sheet 24 has a tensile elasticity at 23°C of, for example, 0.01 MPa or more, or preferably 0.1 MPa or more, and of, for example, 10 MPa or less, or preferably 1 MPa or less.

The thickness of the stretchable support sheet 24 is, for example, 0.05 mm or more and 1 mm or less.

By the transfer of the reflecting layer-phosphor sheet-covered LEDs 10 onto the stretchable support sheet 24, the surface (the upper surface) of the phosphor sheet 5 is exposed from the phosphor sheet 5 around the LEDs 4, while the exposed surfaces 22 (the lower surfaces) of the LEDs 4 in which bumps that are not shown are formed are in contact (in close contact) with the upper surface of the stretchable support sheet 24.

Thereafter, as shown in FIG. 4 (h), the stretchable support sheet 24 is stretched in the plane direction and each of the reflecting layer-phosphor sheet-covered LEDs 10 is peeled from the stretchable support sheet 24.

To be specific, first, as shown by the arrows in FIG. 4 (g), the stretchable support sheet 24 is stretched outwardly in the plane direction. In this way, as shown in FIG. 4 (h), in a state where the reflecting layer-phosphor sheet-covered LEDs 10 are in close contact with the stretchable support sheet 24, the tensile stress is concentrated in the cuts 8; thus, the cuts 8 expand; and the reflecting layer-phosphor sheet-covered LEDs 10 are separated from each other, so that gaps 19 are formed. Each of the gaps 19 is formed into a generally grid shape in plane view so as to separate the reflecting layer-phosphor sheet-covered LEDs 10.

Subsequently, as shown in FIG. 4 (h'), the stretchable support sheet 24 corresponding to the reflecting layer-phosphor sheet-covered LED 10 that is intended to be peeled off is pushed up from the lower side thereof by the pressing member 14. In this way, the reflecting layer-phosphor sheet-covered LED 10 is pushed up upwardly, and the pushed-up reflecting layer-phosphor sheet-covered LED 10 is peeled from the stretchable support sheet 24, while being absorbed by the absorbing member 16.

When the stretchable support sheet 24 is an active energy ray irradiation release sheet, in a case where each of the reflecting layer-phosphor sheet-covered LEDs 10 is peeled from the stretchable support sheet 24, an active energy ray is applied to the stretchable support sheet 24. When the stretchable support sheet 24 is a thermal release sheet, the stretchable support sheet 24 is heated. The pressure-sensitive adhesive force of the stretchable support sheet 24 is reduced by those treatments, so that each of the reflecting layer-phosphor sheet-covered LEDs 10 can be easily and surely peeled from the stretchable support sheet 24.

In this way, each of the reflecting layer-phosphor sheet-covered LEDs 10 that is peeled from the support sheet 1 is obtained.

[Mounting Step]

Thereafter, after the reflecting layer-phosphor sheet-covered LED 10 is selected in accordance with emission wavelength and luminous efficiency, as shown in FIG. 4 (i), the selected reflecting layer-phosphor sheet-covered LED 10 is mounted on the board 9. In this way, the LED device 15 is obtained.

In this method, the stretchable support sheet 24 is stretched in the plane direction and each of the reflecting layer-phosphor sheet-covered LEDs 10 is peeled from the stretchable support sheet 24.

Thus, the gaps 19 are formed around each of the reflecting layer-phosphor sheet-covered LEDs 10, so that each of the reflecting layer-phosphor sheet-covered LEDs 10 can be further easily and surely peeled from the stretchable support sheet 24 using the pick-up device 17.

Additionally, the gap 19 is formed between the reflecting layer-phosphor sheet-covered LED 10 that is intended to be peeled off and the reflecting layer-phosphor sheet-covered LED 10 that is adjacent thereto. Thus, it can be prevented that when the absorbing member 16 is brought into contact with the reflecting layer-phosphor sheet-covered LED 10 that is intended to be peeled off, the absorbing member 16 comes in contact with the reflecting layer-phosphor sheet-covered LED 10 that is adjacent thereto to cause a damage to the reflecting layer-phosphor sheet-covered LED 10.

<Fourth Embodiment>

FIG. 5 shows process drawings for illustrating a fourth embodiment of a method for producing a reflecting layer-phosphor layer-covered LED of the present invention.

In FIG. 5, the same reference numerals are provided for members and steps corresponding to each of those in the first embodiment, and their detailed description is omitted.

In the disposing step (ref: FIG. 1 (a)) in the first embodiment, the support sheet 1 that is made of two layers of the support board 2 and the pressure-sensitive adhesive layer 3 is prepared as a support. Alternatively, for example, the support sheet 1 made of one layer can be also prepared. In such a case, in the phosphor sheet covering step (ref: FIG. 1 (f)), the phosphor sheet 5 is formed from a phosphor resin composition containing an active energy ray curable resin and a phosphor.

[Disposing Step]

As shown in FIG. 5 (a), first, the support sheet 1 is prepared.

The support sheet 1 is not required to have heat resistance with respect to the heating and curing of the phosphor sheet 5 to be described later, so that it can be also selected from a sheet having low heat resistance. The support sheet 1 is capable of supporting the LEDs 4 and is also capable of stretching in the plane direction. Examples thereof may include a thermal release sheet in which the pressure-sensitive adhesive force is capable of being reduced by heating (to be specific, a thermal release sheet such as REVALPHA (manufactured by NITTO DENKO CORPORATION)) or an active energy ray irradiation release sheet in which the pressure-sensitive adhesive force is capable of being reduced by application of an active energy ray (for example, an ultraviolet ray and an electron beam) (to be specific, an active energy ray irradiation release sheet described in Japanese Unexamined Patent Publication No. 2005-286003 or the like). Preferably, a thermal release sheet is used. When the support sheet 1 is an active energy ray irradiation release sheet, the active energy ray curable resin and the irradiation conditions are selected so as not to reduce the pressure-sensitive adhesive force of the support sheet 1 by application of the active energy ray to the phosphor sheet 5.

The support sheet 1 has a Young's modulus at 23°C of, for example, 1 × 10⁴ Pa or more, or preferably 1 × 10⁵ Pa or more, and of, for example, 1 × 10⁷ Pa or less. When the Young's modulus of the support sheet 1 is not less than the above-described lower limit, the stretchability of the support sheet 1 in the plane direction is secured and the stretching (ref: FIG. 5 (e)) of the support sheet 1 in the plane direction to be described later can be smoothly performed. The Young's modulus of the support sheet 1 is obtained by, for example, the compressive elastic modulus in JIS H 7902:2008.

The thickness of the support sheet 1 is, for example, 0.1 mm or more, or preferably 0.2 mm or more, and is, for example, 1 mm or less, or preferably 0.5 mm or less.

Thereafter, the reflecting layers 6 are provided on the support sheet 1.

[Reflecting Layer Covering Step]

The reflecting layer covering step shown in FIG. 5 (b) is performed in the same manner as in the first embodiment.

[Phosphor Sheet Covering Step]

As shown in FIGS. 5 (c) to 5 (e), the phosphor sheet covering step includes the steps of disposing the phosphor sheet 5 that is formed from a phosphor resin composition containing an active energy ray curable resin and a phosphor on the support sheet 1 so as to embed the reflecting layer-covered LEDs 30 (ref: FIG. 5 (c)) (a sheet disposing step), applying an active energy ray to the phosphor sheet 5 to encapsulate the reflecting layer-covered LEDs 30 by the phosphor sheet 5 (ref: FIG. 5 (d)) (an encapsulating step), and cutting the phosphor sheet 5 corresponding to each of the reflecting layer-covered LEDs 30 (ref: FIG. 5 (e)) (a cutting step).

[Sheet Disposing Step]

As shown by the upper portion in FIG. 5 (b), in order to fabricate the phosphor sheet 5, for example, an active energy ray curable resin in an A-stage state and a phosphor, and a filler, which is blended as required, are blended. The obtained mixture is applied to the surface of the release sheet 13 to be thereafter heated, so that a phosphor resin composition is prepared to be a sheet shape in a B-stage state. In this way, the phosphor sheet 5 that is formed from a phosphor resin composition containing a semi-cured material and a phosphor (and a filler blended as required) is fabricated.

Thereafter, the fabricated phosphor sheet 5 is disposed on the upper surface of the support sheet 1 so as to embed the LEDs 4 (an embedding step). That is, the phosphor sheet 5 is disposed on the support sheet 1 so as to cover the upper surfaces and the side surfaces of the LEDs 4.

To be specific, as shown by the arrows in FIG. 5 (b), and in FIG. 5 (c), the phosphor sheet 5 that is laminated on the release sheet 13 is compressively bonded toward the support sheet 1.

That is, in the sheet disposing step, the embedding step in which the LEDs 4 are embedded by the phosphor sheet 5 is performed.

Thereafter, as shown by the phantom lines in FIG. 5 (c), the release sheet 13 is peeled from the phosphor sheet 5 as required.

[Encapsulating Step]

After the sheet disposing step, as shown by the arrow in FIG. 5 (d), an active energy ray is applied to the phosphor sheet 5 in the encapsulating step.

Examples of the active energy ray include an ultraviolet ray and an electron beam. An example of the active energy ray also includes an active energy ray having a spectral distribution in a wavelength region of, for example, 180 nm or more, or preferably 200 nm or more, and of, for example, 460 nm or less, or preferably 400 nm or less.

In the application of the active energy ray, an application device is used. Examples thereof include a chemical lamp, an excimer laser, a black light, a mercury arc, a carbon are, a low pressure mercury lamp, a medium pressure mercury lamp, a high pressure mercury lamp, an extra-high pressure mercury lamp, and a metal halide lamp. Also, an example thereof includes an application device capable of generating an active energy ray that is in the longer wavelength side or in the shorter wavelength side than in the above-described wavelength region.

The amount of irradiation is, for example, 0.001 J/cm² or more, and is, for example, 100 J/cm² or less, or preferably 10 J/cm² or less.

The irradiation duration is, for example, 10 minutes or less, or preferably 1 minute or less, and is, for example, 5 seconds or more.

The active energy ray is applied from the upper side and/or the lower side toward the phosphor sheet 5. Preferably, as shown by the arrow in FIG. 5 (d), the active energy ray is applied from the upper side toward the phosphor sheet 5.

In the application of the active energy ray toward the phosphor sheet 5, when the support sheet 1 is an active energy ray irradiation release sheet, the active energy ray irradiation release sheet and the irradiation conditions are selected so as not to reduce the pressure-sensitive adhesive force of the support sheet 1 by application of the active energy ray to the phosphor sheet 5.

Along with the above-described application of the active energy ray, heating can be also performed.

The timing of the heating may be at the same time with the application of the active energy ray, or before or after the application of the active energy ray. Preferably, the heating is performed after the application of the active energy ray.

The heating conditions are as follows: a temperature of, for example, 50°C or more, or preferably 100°C or more, and of, for example, 250°C or less, or preferably 200°C or less, and a heating duration of, for example, 0.1 minutes or more, and of, for example, 1440 minutes or less, or preferably 180 minutes or less.

The phosphor sheet 5 is completely cured (subjected to final curing) by the above-described application of the active energy ray (and the heating performed as required) to be brought into a C-stage state.

[Cutting Step]

After the sheet disposing step, as shown by the dashed lines in FIG. 5 (e), in the cutting step, the flexible phosphor sheet 5 around the LEDs 4 is cut along the thickness direction.

By the cutting step, the reflecting layer-phosphor sheet-covered LEDs 10, each of which includes the reflecting layer-covered LED 30 and the phosphor sheet 5 that covers the reflecting layer-covered LED 30, are obtained in a state of being in close contact with the support sheet 1.

[Peeling Step]

As shown in FIGS. 5 (f) and 5 (f'), in the cutting step, the support sheet 1 is stretched in the plane direction and each of the reflecting layer-phosphor sheet-covered LEDs 10 is peeled from the support sheet 1 using the pick-up device 17 provided with the pressing member 14 and the absorbing member 16 in the same manner as in the third embodiment (ref: FIGS. 4 (h) and 4 (h')).

Instead of the stretching of the support sheet 1 or in addition to the stretching of the support sheet 1, when the above-described support sheet 1 is a thermal release sheet, the support sheet 1 can be heated at, for example, 50°C or more, or preferably 70°C or more, and at, for example, 200°C or less, or preferably 150°C or less.

Instead of the above-described stretching of the support sheet 1 or in addition to the stretching of the support sheet 1, when the above-described support sheet 1 is an active energy ray irradiation release sheet, an active energy ray can be applied to the support sheet 1.

The pressure-sensitive adhesive force of the support sheet 1 is reduced by those treatments and each of the reflecting layer-phosphor sheet-covered LEDs 10 can be further easily peeled from the support sheet 1.

In this way, as shown in FIG. 5 (f), the reflecting layer-phosphor sheet-covered LED 10 that is peeled from the support sheet 1 is obtained.

[Mounting Step]

As shown in FIG. 5 (g), in the mounting step, the selected reflecting layer-phosphor sheet-covered LED 10 is mounted on the board 9 in the same manner as in the first embodiment. In this way, the LED device 15 is obtained.

In this method, the phosphor sheet 5 that is formed from a phosphor resin composition containing an active energy ray curable resin, which is cured by application of the active energy ray, and a phosphor is laminated on the upper surface of the support sheet 1 so as to cover the reflecting layer-covered LEDs 30. Thereafter, the active energy ray is applied to the phosphor sheet 5 and the reflecting layer-covered LEDs 30 are encapsulated by the phosphor sheet 5. Thus, a damage to the support sheet 1 is suppressed and the reflecting layer-covered LEDs 30 are encapsulated, so that the phosphor is capable of being uniformly dispersed around the reflecting layer-covered LEDs 30.

That is, the phosphor sheet 5 is cured by application of the active energy ray thereto without heating the phosphor sheet 5 or by reducing the heating thereof, so that the reflecting layer-covered LEDs 30 can be encapsulated. Thus, the support sheet 1 that supports the phosphor sheet 5 is not required to have heat resistance, that is, the support sheet 1 having low heat resistance can be used.

Additionally, when the phosphor sheet 5 is completely cured, the irradiation duration for applying an active energy ray can be set to be short, compared to a case where the phosphor sheet 5 is completely cured by heating only.

Also, by cutting the phosphor sheet 5 corresponding to each of the reflecting layer-covered LEDs 30, the reflecting layer-phosphor sheet-covered LEDs 10, each of which includes the reflecting layer-covered LED 30 and the phosphor sheet 5 so as to the cover the surface of the reflecting layer-covered LED 30, are obtained. Thereafter, each of the reflecting layer-phosphor sheet-covered LEDs 10 is peeled from the support sheet 1. Thus, the phosphor sheet 5 supported by the support sheet 1 to which a damage is suppressed is cut with excellent size stability, so that the reflecting layer-phosphor sheet-covered LED 10 having excellent size stability can be obtained.

When the phosphor sheet 5 is cut while being supported by the support sheet 1 in the cutting step and thereafter, the support sheet 1 is heated in the peeling step, the support sheet 1 that supports the phosphor sheet 5 in the cutting step and completes its role is heated and then, each of the reflecting layer-phosphor sheet-covered LEDs 10 is peeled off. In this way, the reflecting layer-phosphor sheet-covered LED 10 having excellent size stability can be efficiently obtained.

Consequently, the reflecting layer-phosphor sheet-covered LED 10 has excellent size stability.

The LED device 15 includes the reflecting layer-phosphor sheet-covered LED 10 having excellent size stability, so that it has excellent reliability and thus, its luminous efficiency is improved.

<Modified Example>

In the fourth embodiment, the support sheet is formed of one layer of the support sheet 1. Alternatively, for example, though not shown, the support sheet can be also formed of two layers of a hard support board that is incapable of stretching in the plane direction and a pressure-sensitive adhesive layer that is laminated on (at one side in the thickness direction of) the support board.

Examples of a hard material for forming the support board include an oxide such as a silicon oxide (silica or the like) and a metal such as stainless steel. The thickness of the support board is, for example, 0.1 mm or more, or preferably 0.3 mm or more, and is, for example, 5 mm or less, or preferably 2 mm or less.

The pressure-sensitive adhesive layer is formed on the entire upper surface of the support board. An example of a pressure-sensitive adhesive material for forming the pressure-sensitive adhesive layer includes a pressure-sensitive adhesive such as an acrylic pressure-sensitive adhesive. The thickness of the pressure-sensitive adhesive layer is, for example, 0.1 mm or more, or preferably 0.2 mm or more, and is, for example, 1 mm or less, or preferably 0.5 mm or less.

Preferably, as shown by the lower portion in FIG. 5 (a), one layer of the support sheet 1 that is capable of stretching in the plane direction is used as a support sheet.

According to this, in the peeling step shown in FIG. 5 (f), the support sheet 1 is stretched in the plane direction and each of the reflecting layer-phosphor sheet-covered LEDs 10 is peeled from the support sheet 1. Thus, as shown in FIG. 5 (f'), each of the reflecting layer-phosphor sheet-covered LEDs 10 can be easily and surely peeled from the support sheet 1 using the above-described pick-up device 17.

A hard support board is not provided in the support sheet 1, so that as referred in FIG. 5 (f'), the support sheet 1 and the corresponding reflecting layer-phosphor sheet-covered LED 10 can be pushed up from the lower side by the pressing member 14 in the pick-up device 17.

Additionally, a hard support board is not required to be laminated on the pressure-sensitive adhesive layer, so that the production process can be simplified.

<Fifth Embodiment>

FIG. 6 shows process drawings for illustrating a fifth embodiment of a method for producing a reflecting layer-phosphor layer-covered LED of the present invention.

In FIG. 6, the same reference numerals are provided for members and steps corresponding to each of those in the first embodiment, and their detailed description is omitted.

[Disposing Step]

As referred in FIG. 6 (a), in the disposing step, the pressure-sensitive adhesive layer 3 is formed from a material in which the pressure-sensitive adhesive force is capable of being reduced by application of an active energy ray as an active energy ray irradiation release layer (sheet). Or, the pressure-sensitive adhesive layer 3 is formed of a pressure-sensitive adhesive layer such as an acrylic pressure-sensitive adhesive layer. Also, the pressure-sensitive adhesive layer 3 can be formed of an active energy ray irradiation release layer (sheet) described in Japanese Unexamined Patent Publication No. 2001-308116.

The support board 2 is formed of a hard material that is incapable of stretching at least in the plane direction. The material is not particularly limited as long as its hardness properties are secured. The material is appropriately selected from, for example, an active energy ray blocking material that blocks an active energy ray, an active energy ray transmissive material that allows an active energy ray to transmit therethrough, and furthermore, an active energy ray semi-transmissive material that allows an active energy ray to partially transmit (semi-transmit) therethrough. To be specific, examples of the material for forming the support board 2 include an oxide such as a silicon oxide (silica or the like) and alumina, a metal such as stainless steel, and silicon.

[Reflecting Layer Covering Step]

As shown in FIG. 6 (b), the reflecting layer covering step is performed in the same manner as in the first embodiment.

[Phosphor Sheet Covering Step]

As shown in FIGS. 6 (c) and 6 (d), the phosphor sheet covering step is performed in the same manner as in the first embodiment.

[Peeling Step]

In order to peel each of the reflecting layer-phosphor sheet-covered LEDs 10 from the upper surface of the pressure-sensitive adhesive layer 3, first, as shown by a down arrow in FIG. 6 (f), an active energy ray is applied from the upper side (one side in the thickness direction) to the pressure-sensitive adhesive layer 3 via the phosphor sheet 5.

Examples of the active energy ray include an ultraviolet ray and an electron beam. An example of the active energy ray also includes an active energy ray having a spectral distribution in a wavelength region of, for example, 180 nm or more, or preferably 200 nm or more, and of, for example, 460 nm or less, or preferably 400 nm or less.

In the application of the active energy ray, an application device is used. Examples thereof include a chemical lamp, an excimer laser, a black light, a mercury arc, a carbon arc, a low pressure mercury lamp, a medium pressure mercury lamp, a high pressure mercury lamp, an extra-high pressure mercury lamp, and a metal halide lamp. Also, an example thereof includes an application device capable of generating an active energy ray that is in the longer wavelength side or in the shorter wavelength side than in the above-described wavelength region.

The amount of irradiation is, for example, 0.001 J/cm² or more, or preferably 0.01 J/cm² or more, and is, for example, 100 J/cm² or less, or preferably 10 J/cm² or less. When the amount of irradiation is not less than the above-described lower limit, the pressure-sensitive adhesive force of the pressure-sensitive adhesive layer 3 can be surely and efficiently reduced. On the other hand, when the amount of irradiation is not more than the above-described upper limit, an increase in cost can be suppressed and a damage to a device can be effectively prevented.

The irradiation duration is, for example, 10 minutes or less, or preferably 1 minute or less, and is, for example, 5 seconds or more. When the upper limit of the irradiation duration is not more than the above-described upper limit, a duration required for the peeling of each of the reflecting layer-covered LEDs 30 can be shortened.

All or a part of the active energy ray transmits through the phosphor sheet 5 from the upper side to be applied to the pressure-sensitive adhesive layer 3.

By the application of the active energy ray, the pressure-sensitive adhesive force of the pressure-sensitive adhesive layer 3 is reduced.

In this state, as shown by an up arrow in FIG. 6 (f), each of the reflecting layer-phosphor sheet-covered LEDs 10 is peeled from the pressure-sensitive adhesive layer 3. In order to peel each of the reflecting layer-phosphor sheet-covered LEDs 10 from the pressure-sensitive adhesive layer 3, though not shown, a pick-up device that is provided with an absorbing member such as a collet can be used as required. To be specific, each of the reflecting layer-phosphor sheet-covered LEDs 10 can be peeled from the pressure-sensitive adhesive layer 3, while being absorbed by an absorbing member.

In this way, each of the reflecting layer-phosphor sheet-covered LEDs 10 that is peeled from the pressure-sensitive adhesive layer 3 is obtained.

[Mounting Step]

Thereafter, after the reflecting layer-phosphor sheet-covered LED 10 is selected in accordance with emission wavelength and luminous efficiency, as shown in FIG. 6 (g), the selected reflecting layer-phosphor sheet-covered LED 10 is mounted on the board 9. In this way, the LED device 15 is obtained.

According to this method, in the peeling step, an active energy ray is applied from the upper side to the pressure-sensitive adhesive layer 3 via the phosphor sheet 5. Then, the active energy ray transmits through the phosphor sheet 5 to be applied to the pressure-sensitive adhesive layer 3. Thus, it is not required that the support board 2 is formed from a board material that allows an active energy ray to transmit therethrough and the active energy ray transmits through the support board 2. As a result, as the support board 2, not only an active energy ray transmissive support board is used, but also an active energy ray blocking support board can be selected.

After the cutting step, the peeling step is performed. That is, in the cutting step, the phosphor sheet 5 can be cut, while the LEDs 4 and the phosphor sheet 5 are supported by the support sheet 1 including the hard support board 2. Thus, the reflecting layer-phosphor sheet-covered LED 10 having excellent size stability can be obtained.

Furthermore, in this method, an active energy ray is applied to the pressure-sensitive adhesive layer 3 in the peeling step, so that deformation of the support sheet 1 caused by heating is prevented and the size stability can be further improved, compared to a method in which the pressure-sensitive adhesive force of the pressure-sensitive adhesive layer 3 is reduced by heating of the pressure-sensitive adhesive layer 3.

Consequently, the reflecting layer-phosphor sheet-covered LED 10 has excellent size stability.

The LED device 15 includes the reflecting layer-phosphor sheet-covered LED 10 having excellent size stability, so that it has excellent reliability and thus, its luminous efficiency is improved.

<Modified Example>

In the peeling step in FIG. 6 (f), an active energy ray is applied from the upper side (one side in the thickness direction) only to the pressure-sensitive adhesive layer 3. However, in the present invention, an active energy ray may be applied at least from the upper side (one side in the thickness direction). For example, when the support board 2 is formed from an active energy ray transmissive material or an active energy ray semi-transmissive material, an active energy ray can be also applied from both of the upper side and the lower side (one side and the other side in the thickness direction) to the pressure-sensitive adhesive layer 3. In such a case, of the active energy ray applied from the lower side of the support sheet 1, all or a part of the active energy ray transmits through the support board 2 to reach the pressure-sensitive adhesive layer 3.

According to the modified example, in the peeling step, a duration required for reducing the pressure-sensitive adhesive force of the pressure-sensitive adhesive layer 3, that is, the irradiation duration of an active energy ray can be further shortened and the production efficiency of the reflecting layer-phosphor sheet-covered LED 10 can be improved.

<Sixth Embodiment>

FIG. 7 shows process drawings for illustrating a sixth embodiment of a method for producing a reflecting layer-phosphor layer-covered LED of the present invention.

In FIG. 7, the same reference numerals are provided for members and steps corresponding to each of those in the second embodiment, and their detailed description is omitted.

In the second embodiment, the support board peeling step (ref: FIG. 3 (f)) is performed after the cutting step (ref: FIG. 3 (f)) and before the peeling step (ref: FIG. 3 (g)). Alternatively, for example, as shown in FIG. 7, the support board peeling step can be also performed after the encapsulating step (ref: FIG. 7 (e)) and before the cutting step (ref: FIG. 7 (f)).

That is, the encapsulating step (ref: FIG. 7 (e)), the support board peeling step (ref: the dashed lines in FIG. 7 (e)), and the cutting step (ref: FIG. 7 (f)) are sequentially performed.

<Seventh Embodiment>

FIG. 8 shows process drawings for illustrating a seventh embodiment of a method for producing a reflecting layer-phosphor layer-covered LED of the present invention. FIG. 9 shows a plan view of the support sheet shown in FIG. 8 (a).

In FIG. 8, the pressure-sensitive adhesive layer 3 to be described later is omitted so as to clearly show the relative arrangement of the support board 2, the reference marks 18, and through holes 21 to be described later.

In FIG. 8, the same reference numerals are provided for members and steps corresponding to each of those in the first embodiment, and their detailed description is omitted.

[Disposing Step]

In the first embodiment, in the disposing step, as shown in FIGS. 1 (a) and 2, the support board 2 is formed into a flat plate shape. Alternatively, for example, as shown in FIGS. 8 (a) and 9, the through holes 21 can be formed in the support board 2.

The through holes 21 are formed to pass through the support board 2 in the up-down direction so as to allow the pressing member 14 to insert thereinto in the peeling step (ref: FIG. 8 (e')).

As shown in FIG. 9, a plurality of the through holes 21 are provided at spaced intervals to each other in the support board 2 corresponding to the LEDs 4 that are subsequently disposed. The through holes 21 are, for example, disposed so as to allow each of the reflecting layer-phosphor sheet-covered LEDs 10 to be pressed when the reflecting layer-phosphor sheet-covered LED 10 are singulated with the reference marks 18 as a reference.

To be more specific, a plurality of the through holes 21 are disposed in alignment in the support sheet 1 so as to be spaced apart from each other at equal intervals in the front-rear and the right-left directions in plane view.

The shape of each of the through holes 21 is, for example, formed into a circular shape in plane view. In the size thereof, the hole diameter is, for example, 0.1 mm or more, or preferably 0.2 mm or more, and is, for example, 1 mm or less, or preferably 0.7 mm or less.

The size of each of the through holes 21 with respect to that of each of the LEDs 4 is, for example, 10 % or more, or preferably 20 % or more, and is, for example, 90 % or less, or preferably 80 % or less.

A pressure-sensitive adhesive material for forming the pressure-sensitive adhesive layer 3 can be widely selected from materials that can be usually used as a pressure-sensitive adhesive, in addition to materials in which the pressure-sensitive adhesive force is capable of being reduced by application of ultraviolet ray, a chemical solution, or heating.

[Peeling Step]

As shown in FIG. 8 (e), the peeling step is a step in which each of the reflecting layer-phosphor sheet-covered LEDs 10 is peeled from the pressure-sensitive adhesive layer 3. As shown in FIG. 8 (e'), the pressure-sensitive adhesive layer 3 is pressed by the pressing member 14 via the through hole 21 using the pick-up device 17 that is provided with the pressing member 14 such as a needle and the absorbing member 16 such as a collet, so that each of the reflecting layer-phosphor sheet-covered LEDs 10 is peeled from the support board 2 and the pressure-sensitive adhesive layer 3.

To be more specific, first, the support sheet 1 is placed in the pick-up device 17. Then, the pressing member 14 is disposed from the lower side (the other side in the thickness direction) in opposed relation to the through hole 21 corresponding to the reflecting layer-phosphor sheet-covered LED 10 that is intended to be peeled off.

The pressing member 14 is inserted into the through hole 21 from the lower side.

Then, the pressure-sensitive adhesive layer 3 corresponding to the through hole 21 is pressed relatively toward the upper side (one side in the thickness direction) with respect to the support board 2 and the pressure-sensitive adhesive layer 3 is pushed up along with the reflecting layer-phosphor sheet-covered LED 10.

The pushed-up reflecting layer-phosphor sheet-covered LED 10 is absorbed by the absorbing member 16.

The reflecting layer-phosphor sheet-covered LED 10 is absorbed by the absorbing member 16 and is further moved relatively toward the upper side (one side in the thickness direction) with respect to the support board 2. Thereafter, the reflecting layer-phosphor sheet-covered LED 10 is peeled from the pressure-sensitive adhesive layer 3.

Before the peeling step, the pressure-sensitive adhesive force of the pressure-sensitive adhesive layer 3 is reduced by application of ultraviolet ray, a chemical solution, or heating as required and then, each of the reflecting layer-phosphor sheet-covered LEDs 10 can be also peeled off.

In this way, as shown in FIG. 8 (e), each of the reflecting layer-phosphor sheet-covered LEDs 10 that is peeled from the support sheet 1 is obtained.

According to this method, in the disposing step, the hard support board 2 in which the through hole 21 is formed in advance is prepared and in the peeling step, the pressing member 14 is inserted into the through hole 21 in the support board 2 using the above-described pick-up device 17 to press the pressure-sensitive adhesive layer 3, so that each of the reflecting layer-phosphor sheet-covered LEDs 10 is peeled from the pressure-sensitive adhesive layer 3.

Thus, each of the LEDs 4 can be peeled from the pressure-sensitive adhesive layer 3 without requiring a step in which the pressure-sensitive adhesive force of the pressure-sensitive adhesive layer 3 is reduced before the peeling step.

As a result, the number of steps required for production of the reflecting layer-phosphor sheet-covered LED 10 can be reduced.

A material for forming the pressure-sensitive adhesive layer 3 can be widely selected, in addition to materials in which the pressure-sensitive adhesive force is capable of being reduced by application of ultraviolet ray, a chemical solution, or heating.

As a result, the freedom in process planning can be improved.

The number of steps required for the production of the reflecting layer-phosphor sheet-covered LED 10 is reduced, so that its cost can be reduced.

The LED device 15 includes the above-described reflecting layer-phosphor sheet-covered LED 10, so that its cost can be reduced.

[Modified Example]

In FIG. 9, each of the through holes 21 is formed into a circular shape in plane view. However, the shape thereof is not particularly limited and can be formed into an appropriate shape such as a generally rectangular shape in plane view or a generally triangular shape in plane view.

In the seventh embodiment, first, in the cutting step, a plurality of the reflecting layer-covered LEDs 30 and the phosphor sheet 5 that covers the surfaces of a plurality of the reflecting layer-covered LEDs 30 (hereinafter, these are defined as phosphor sheet-reflecting layer-covered LEDs 35) are singulated into each of the reflecting layer-phosphor sheet-covered LEDs 10. Next, in the peeling step, each of the reflecting layer-phosphor sheet-covered LEDs 10 is peeled from the pressure-sensitive adhesive layer 3. Alternatively, in the cutting step, the phosphor sheet-reflecting layer-covered LEDs 35 are not sigulated and in the peeling step, the phosphor sheet-reflecting layer-covered LEDs 35 can be peeled from the pressure-sensitive adhesive layer 3.

FIG. 10 is a modified example of the peeling step shown in FIGS. 8 (e) and 8 (e') and shows a modified example of peeling the phosphor sheet-reflecting layer-covered LEDs 35 (a plurality of the reflecting layer-phosphor sheet-covered LEDs 10 that are not singulated).

In the modified example, as shown in FIG. 9, the pick-up device 17 is provided with a plurality of the pressing members 14 and a plurality of the absorbing members 16 corresponding to a plurality of the LEDs 4. A plurality of the pressing members 14 move relative to one another in the up-down direction at the same time.

In order to peel the phosphor sheet-reflecting layer-covered LEDs 35, first, the phosphor sheet-reflecting layer-covered LEDs 35 are placed in the pick-up device 17 and each of a plurality of the pressing members 14 is disposed from the lower side (the other side in the thickness direction) in opposed relation to each of a plurality of the through holes 21.

A plurality of the pressing members 14 are simultaneously inserted into a plurality of the through holes 21 from the lower side.

Then, the entire pressure-sensitive adhesive layer 3 is pressed relatively toward the upper side (one side in the thickness direction) with respect to the support board 2 and the entire pressure-sensitive adhesive layer 3 is pushed up along with the phosphor sheet-reflecting layer-covered LEDs 35.

The pushed-up phosphor sheet-reflecting layer-covered LEDs 35 are absorbed by a plurality of the absorbing members 16.

The phosphor sheet-reflecting layer-covered LEDs 35 are absorbed by a plurality of the absorbing members 16 and are further moved relatively toward the upper side (one side in the thickness direction) with respect to the support board 2. Thereafter, the phosphor sheet-reflecting layer-covered LEDs 35 are peeled from the pressure-sensitive adhesive layer 3.

Thereafter, in the cutting step, the phosphor sheet-reflecting layer-covered LEDs 35 that are peeled from the pressure-sensitive adhesive layer 3 are sigulated corresponding to the reflecting layer-covered LEDs 30 and each of the reflecting layer-phosphor sheet-covered LEDs 10 is obtained.

<Eighth Embodiment>

FIG. 11 shows process drawings for illustrating an eighth embodiment of a method for producing a reflecting layer-phosphor layer-covered LED of the present invention.

In FIG. 11, the same reference numerals are provided for members and steps corresponding to each of those in the first embodiment, and their detailed description is omitted.

In the first embodiment, as shown in FIG. 1 (b), the reflecting layers 6 are provided on the upper surface of the pressure-sensitive adhesive layer 3 in a pattern of corresponding to the lower surfaces of the LEDs 4. Alternatively, for example, the reflecting layer 6 can be also provided on the entire upper surface of the pressure-sensitive adhesive layer 3.

[Disposing Step]

In the disposing step, as shown in FIG. 11 (b), the reflecting layer 6 is formed on the entire upper surface of the pressure-sensitive adhesive layer 3 by, for example, a laminating method or an application method. Preferably, a laminating method in which a plate-shaped phosphor sheet is laminated on the pressure-sensitive adhesive layer 3 is used, or an application method in which a liquid reflecting resin composition is applied to the pressure-sensitive adhesive layer 3 by a method such as a casting, a spin coating, or a roll coating is used.

[Reflecting Layer Covering Step]

In the reflecting layer covering step, as shown in FIG. 11 (b), a plurality of the LEDs 4 are prepared to be disposed on the support sheet 1.

As shown by the arrows in FIG. 11 (b), a plurality of the LEDs 4 are laminated with respect to the pressure-sensitive adhesive layer 3 and the reflecting layer 6. To be specific, the exposed surfaces 22 of the LEDs 4 are compressively bonded to the reflecting layer 6 in a B-stage state and the terminals 31 of the LEDs 4 are allowed to break through the reflecting layer 6, so that the lower end portions of the terminals 31 are pressed into the pressure-sensitive adhesive layer 3. That is, when the exposed surfaces 22 of the LEDs 4 adhere to the reflecting layer 6, the thickness of each of the terminals 31 is thicker than that of the reflecting layer 6, so that the lower end portions of the terminals 31 are defined as the extruded portions 23 that break through the reflecting layer 6 and enter the pressure-sensitive adhesive layer 3. The extruded portions 23 fall into (sink into) the pressure-sensitive adhesive layer 3 in a B-stage state.

In this way, the exposed surfaces 22 of the lower surfaces are covered with the reflecting layer 6.

In this way, the reflecting layer-covered LEDs 30, each of which includes the LED 4 and the reflecting layer 6 that is formed so as to cover the exposed surface 22 on the lower surface thereof, are obtained in a state of being in close contact with the pressure-sensitive adhesive layer 3.

In this method, the reflecting layer 6 is formed on the entire upper surface of the pressure-sensitive adhesive layer 3 by an easy method without forming a predetermined pattern. Thus, a step of forming a pattern is omitted and the reflecting layer-covered LED 30 and furthermore, the reflecting layer-phosphor sheet-covered LED 10 and the LED device 15 can be easily obtained, so that the production cost can be reduced.

<Ninth Embodiment>

FIG. 12 shows process drawings for illustrating a ninth embodiment of a method for producing a reflecting layer-phosphor layer-covered LED of the present invention.

In FIG. 12, the same reference numerals are provided for members and steps corresponding to each of those in the first embodiment, and their detailed description is omitted.

In the first embodiment, as shown in FIG. 1 (a), the support of the present invention is described as the support sheet 1. Alternatively, for example, as shown in FIG. 12, the support of the present invention can be defined as the board 9.

This method includes the steps of forming the phosphor sheet 5 so as to cover the upper surfaces and the side surfaces of the LEDs 4 to prepare phosphor layer-covered LEDs 40 (ref: the upper portion in FIG. 12 (a)) (a phosphor sheet covering step), disposing the reflecting layers 6 on (at one side in the thickness direction of) the board 9 (ref: the lower portion in FIG. 12 (a)) (a disposing step), and after the disposing step, disposing the phosphor layer-covered LEDs 40 provided with the terminals 31 on the lower surfaces thereof and having the upper surfaces and the side surfaces covered with the phosphor sheet 5 on (at one side in the thickness direction of) the board 9 so that the lower surfaces of the LEDs 4 are covered with the reflecting layers 6 (ref: FIG. 12 (b)) (a reflecting layer covering step).

[Phosphor Sheet Covering Step]

In the phosphor sheet covering step shown by the upper portion in FIG. 12 (a), in order to prepare the phosphor sheet 5 so as to cover the upper surfaces and the side surfaces of the LEDs 4, the upper surfaces and the side surfaces of the LEDs 4 are formed to be covered with the phosphor sheet 5 without providing the reflecting layers 6 on the pressure-sensitive adhesive layer 3 in conformity with the method of the first embodiment. In this way, the phosphor layer-covered LEDs 40 in which the upper surfaces and the side surfaces are covered with the phosphor sheet 5 are prepared.

[Disposing Step]

In the disposing step, the reflecting layers 6 are formed in a pattern of exposing the terminals 31 of the LEDs 4.

[Reflecting Layer Covering Step]

In the reflecting layer covering step, each of the LEDs 4, to be specific, each of the phosphor layer-covered LEDs 40 is mounted on the board 9.

The board 9 is formed into a generally flat plate shape. To be specific, the board 9 is formed of a laminated board in which a conductive layer (not shown) including a terminal (not shown) and a wire (not shown), as a circuit pattern, is laminated on an insulating board. The insulating board is, for example, formed of a silicon board, a ceramic board, or a polyimide resin board. Preferably, the insulating board is formed of a ceramic board, to be specific, a sapphire (Al₂O₃) board.

The conductive layer is formed of a conductor such as gold, copper, silver, or nickel. The thickness of the board 9 is, for example, 30 to 1500 µm, or preferably 500 to 1000 µm.

A terminal (not shown) of the board 9 and the terminal 31 of each of the phosphor layer-covered LEDs 40 are connected to each other and each of the phosphor layer-covered LEDs 40 is flip-chip mounted on the board 9.

Although not shown, the phosphor layer-covered LEDs 40 are encapsulated by the encapsulating protective layer 20 as required.

Thereafter, the board 9 is cut, so that the phosphor layer-covered LEDs 40 are singulated.

<Tenth Embodiment>

FIG. 13 shows process drawings for illustrating a tenth embodiment of a method for producing a reflecting layer-phosphor layer-covered LED of the present invention.

In FIG. 13, the same reference numerals are provided for members and steps corresponding to each of those in the first embodiment, and their detailed description is omitted.

In the ninth embodiment, in the disposing step, the reflecting layers 6 are formed on the upper surface of the board 9 in a pattern of exposing the terminals. Alternatively, for example, as shown by the lower portion in FIG. 13 (a), the reflecting layer 6 can be also formed on the entire upper surface of the board 9.

[Disposing Step]

To be specific, in the disposing step, as shown in FIG. 13 (a), the reflecting layer 6 is formed on the entire upper surface of the board 9 by a laminating method or an application method. Preferably, an application method in which a liquid reflecting resin composition is applied to the board 9 by a method such as a casting, a spin coating, or a roll coating is used.

<Others>

In the above-described description, the phosphor sheet 5 is provided on both surfaces of the upper surfaces and the side surfaces of the LEDs 4. Alternatively, for example, though not shown, the phosphor sheet 5 can be provided on the upper surfaces of the LEDs 4 only.

In such a case, the phosphor sheet 5 can be also formed of, for example, a ceramic plate containing a phosphor.

<Eleventh Embodiment>

FIG. 14 shows process drawings for illustrating an eleventh embodiment of a method for producing a reflecting layer-phosphor layer-covered LED of the present invention. FIG. 15 shows a plan view of the phosphor sheet-embedded LEDs shown in FIG. 14 (e). FIG. 16 shows process drawings for illustrating a method for producing the embedding-reflector sheet shown in FIG. 14 (c).

In the eleventh embodiment, the same reference numerals are provided for members and steps corresponding to each of those in the first embodiment, and their detailed description is omitted.

In the first embodiment, as shown in FIG. 1 (c), the phosphor sheet 5 in which a phosphor is uniformly (uniformly at least in the plane direction) dispersed is illustrated as a phosphor sheet that is one example of the phosphor layer of the present invention. Alternatively, for example, as shown in FIGS. 14 (c) and 15, an embedding-reflector sheet 64 that includes embedding portions 33 containing a phosphor as cover portions and a reflector portion (a second reflecting portion that is different from the reflecting layer 6) 34 surrounding the embedding portions 33 can be also illustrated as a phosphor sheet.

As shown in FIG. 15, a plurality of the embedding portions 33 are provided at spaced intervals to each other as portions that embed a plurality of the LEDs 4 in the embedding-reflector sheet 64. Each of the embedding portions 33 is formed into a generally circular shape in plane view. To be specific, as shown in FIG. 14 (c), each of the embedding portions 33 is formed into a generally conical trapezoidal shape in which its width is gradually reduced toward the lower side.

The diameter (the maximum length) of the lower end portion of each of the embedding portions 33 is larger than the maximum length in the plane direction of each of the LEDs 4. To be specific, the diameter (the maximum length) of the lower end portion thereof with respect to the maximum length in the plane direction of each of the LEDs 4 is, for example, 200 % or more, preferably 300 % or more, or more preferably 500 % or more, and is, for example, 3000 % or less. To be more specific, the diameter (the maximum length) of the lower end portion of each of the embedding portions 33 is, for example, 5 mm or more, or preferably 7 mm or more, and is, for example, 300 mm or less, or preferably 200 mm or less.

The diameter (the maximum length) of the upper end portion of each of the embedding portions 33 is larger than the diameter (the maximum length) of the lower end portion thereof. To be specific, the diameter (the maximum length) of the upper end portion thereof is, for example, 7 mm or more, or preferably 10 mm or more, and is, for example, 400 mm or less, or preferably 250 mm or less.

The gap between the embedding portions 33 (the minimum gap, to be specific, the gap between the upper end portions of the embedding portions 33) is, for example, 20 mm or more, or preferably 50 mm or more, and is, for example, 1000 mm or less, or preferably 200 mm or less.

The embedding portions 33 are formed from the above-described phosphor resin composition. When the phosphor resin composition contains a curable resin, the embedding portions 33 are formed in a B-stage state.

As shown in FIG. 15, the reflector portion 34 is continuous at the circumference end portion of the embedding-reflector sheet 64 and is disposed between the embedding portions 33. The reflector portion 34 is formed into a generally grid shape in plane view surrounding each of the embedding portions 33.

The reflector portion 34 is formed from the above-described reflecting resin composition.

Next, a method for producing the embedding-reflector sheet 64 is described with reference to FIGS. 15 and 16.

In this method, first, as shown in FIG. 16 (a), a pressing device 135 is prepared.

The pressing device 135 is provided with a support board 36 and a die 37 that is disposed in opposed relation to the upper side of the support board 36.

The support board 36 is, for example, formed of a metal such as stainless steel into a generally rectangular flat plate shape.

The die 37 is, for example, formed of a metal such as stainless steel and integrally includes a flat plate portion 38 and extruded portions 39 that are formed to be extruded downwardly from the flat plate portion 38.

The flat plate portion 38 is formed into the same shape as that of the support board 36 in plane view.

In the die 37, a plurality of the extruded portions 39 are disposed at spaced intervals to each other in the plane direction so as to correspond to the embedding portions 33. That is, each of the extruded portions 39 is formed into a generally conical trapezoidal shape in which its width is gradually reduced from the lower surface of the flat plate portion 38 toward the lower side. To be specific, each of the extruded portions 39 is formed into a tapered shape in which its width is gradually reduced toward the lower side in front sectional view and side sectional view. That is, each of the extruded portions 39 is formed into the same shape as that of each of the embedding portions 33.

As shown in FIG. 16 (a), a spacer 140 is provided on the upper surface of the circumference end portion of the support board 36. The spacer 140 is, for example, formed of a metal such as stainless steel and is disposed so as to surround a plurality of the embedding portions 33 when projected in the thickness direction. The spacer 140 is disposed on the support board 36 so as to be included in the die 37, to be specific, to be overlapped with the circumference end portion of the flat plate portion 38, when projected in the thickness direction.

The thickness of the spacer 140 is set so as to be the total thickness of the thickness of a releasing sheet 49 to be described later and that of each of the extruded portions 39. To be specific, the thickness of the spacer 140 is, for example, 0.3 mm or more, or preferably 0.5 mm or more, and is, for example, 5 mm or less, or preferably 3 mm or less.

In the pressing device 135, the die 37 is configured to be replaceable with that having a different shape. To be specific, in the pressing device 135, the die 37 having the extruded portions 39 shown in FIG. 16 (a) is configured to be replaceable with the die 37 in a flat plate shape having no extruded portion 39 shown in FIG. 16 (c) to be described later.

As shown in FIG. 16 (a), the releasing sheet 49 is disposed at the inner side of the spacer 140 on the upper surface of the support board 36. The circumference end surfaces of the releasing sheet 49 are, on the upper surface of the support board 36, formed so as to be in contact with the inner side surfaces of the spacer 140. The thickness of the releasing sheet 49 is, for example, 10 µm or more, or preferably 30 µm or more, and is, for example, 200 µm or less, or preferably 150 µm or less.

Next, in the pressing device 135 shown in FIG. 16 (a), a reflector sheet 42 is disposed on the upper surface of the releasing sheet 49.

In order to dispose the reflector sheet 42 on the upper surface of the releasing sheet 49, for example, the following method is used: that is, a laminating method in which the reflector sheet 42 formed from the above-described reflecting resin composition is laminated on the upper surface of the releasing sheet 49 or an application method in which the above-described liquid reflecting resin composition is applied to the upper surface of the releasing sheet 49.

In the laminating method, the reflecting resin composition is prepared in an A-stage state by blending the above-described resin and light reflecting component, and the filler, which is added as required, to be uniformly mixed.

Subsequently, in the laminating method, the reflecting resin composition in an A-stage state is applied to the surface of a release sheet that is not shown by an application method such as a casting, a spin coating, or a roll coating and thereafter, the applied product is heated to be brought into a B-stage state or C-stage state. An example of the release sheet includes the same one as the above-described release sheet 13.

Alternatively, for example, the reflecting resin composition in an A-stage state is applied to the surface of a release sheet that is not shown using a screen printing or the like by the above-described application method and thereafter, the applied product is heated to form the reflector sheet 42 in a B-stage state or C-stage state.

Thereafter, the reflector sheet 42 is transferred onto the releasing sheet 49. Subsequently, the release sheet that is not shown is peeled off.

On the other hand, in the application method, the above-described reflecting resin composition in an A-stage state is applied to the upper surface of the releasing sheet 49 using a screen printing or the like and thereafter, the applied product is heated to form the reflector sheet 42 in a B-stage state.

The thickness of the reflector sheet 42 is, for example, 0.3 mm or more, or preferably 0.5 mm or more, and is, for example, 5 mm or less, or preferably 3 mm or less.

Subsequently, as shown by the arrows in FIG. 16 (a), and in FIG. 16 (b), the reflector sheet 42 is pressed by the pressing device 135.

To be specific, the die 37 is pushed down with respect to the support board 36. To be more specific, the die 37 is pushed downwardly so that the extruded portions 39 pass through the reflector sheet 42 in the thickness direction. Along with this, the circumference end portion of the flat plate portion 38 in the die 37 is brought into contact with the upper surface of the spacer 140.

In this way, as shown in FIG. 16 (b), in the reflector sheet 42, through holes 41, which pass through the reflector sheet 42 in the thickness direction and are in shapes corresponding to the extruded portions 39, are formed.

In the pushing down of the die 37, when the reflecting resin composition contains a thermosetting resin in a B-stage state, a heater (not shown) is built in the die 37 in advance and the reflector sheet 42 can be also heated by the heater. In this way, the reflecting resin composition is completely cured (is brought into a C-stage state).

The heating temperature is, for example, 80°C or more, or preferably 100°C or more, and is, for example, 200°C or less, or preferably 180°C or less.

In this way, the reflector portion 34 is formed on the releasing sheet 49.

Thereafter, as shown in FIG. 16 (c), a pressing state of the pressing device 135 is released. To be specific, the die 37 is pulled up.

Subsequently, the die 37 including the flat plate portion 38 and the extruded portions 39 is replaced with the die 37 including the flat plate portion 38 only.

Along with this, the phosphor sheet 5 is disposed on the reflector portion 34.

To be specific, the phosphor sheet 5 is disposed on the upper surface of the reflector portion 34 so as to cover the through holes 41.

When the phosphor resin composition contains a curable resin, the phosphor sheet 5 in a B-stage state is disposed on the reflector portion 34. The phosphor sheet 5 in a B-stage state can retain its flat plate shape to some extent, so that it is disposed on the upper surface of the reflector portion 34 so as to cover the through holes 41 without falling into the inside of the through holes 41.

The phosphor sheet 5 is formed to be more flexible than the reflector portion 34 (to be specific, the reflector portion 34 in a C-stage state when the reflecting resin composition of the reflector sheet 42 contains a curable resin). To be specific, the reflector portion 34 is formed to have non-deformable hardness by the next pressing (ref: FIG. 16 (d)), while the phosphor sheet 5 is formed to have deformable flexibility by the next pressing.

Next, as shown in FIG. 16 (d), the phosphor sheet 5 is pressed by the pressing device 135. To be specific, the die 37 made of the flat plate portion 38 is pushed down toward the support board 36. Along with this, the circumference end portion of the flat plate portion 38 is brought into contact with the upper surface of the spacer 140. The lower surface of the flat plate portion 38 is in contact with the upper surface of the reflector portion 34.

In this way, the relatively flexible phosphor sheet 5 is pressed from the upper side by the flat plate portion 38 to fill the through holes 41. On the other hand, the relatively hard reflector portion 34 is not deformed and houses the embedding portions 33 in the through holes 41 therein.

When the curable resin is a thermosetting resin, the phosphor sheet 5 can be heated by a heater that is built in the flat plate portion 38.

In this way, the embedding portions 33 are formed in the through holes 41 in the reflector portion 34.

In this way, the embedding-reflector sheet 64 including the embedding portions 33 and the reflector portion 34 is obtained between the support board 36 and the die 37.

Thereafter, as shown in FIG. 16 (e), the die 37 is pulled up and subsequently, the embedding-reflector sheet 64 is peeled from the releasing sheet 49.

Next, using the embedding-reflector sheet 64 shown in FIG. 16 (e), a method for producing the reflecting layer-phosphor sheet-covered LED 10 and the LED device 15, which has different steps from those in the above-described embodiment, is described in detail with reference to FIG. 14.

[Phosphor Sheet Covering Step]

As shown by the upper side view in FIG. 14 (c), the embedding-reflector sheet 64 is disposed above the support sheet 1 so that each of the embedding portions 33 is formed into a tapered shape in which its width is gradually reduced toward the lower side.

That is, each of a plurality of the embedding portions 33 is disposed in opposed relation to each of a plurality of the LEDs 4. To be specific, each of the embedding portions 33 is disposed to be opposed to the center of each of the LEDs 4 and each of the LEDs 4 is also disposed at spaced intervals to the inner side of the reflector portion 34 in plane view.

Subsequently, as shown in FIG. 14 (d), the embedding-reflector sheet 64 is pressed. In this way, each of the LEDs 4 is embedded in each of the embedding portions 33 so that the upper surface and the side surfaces of the LED 4 are covered with the embedding portion 33.

[Encapsulating Step]

As shown in FIG. 14 (e), in the encapsulating step, when the phosphor resin composition contains a curable resin, the phosphor sheet 5 is cured. In this way, the embedding portions 33 are completely cured. In this way, each of the LEDs 4 is encapsulated by each of the embedding portions 33.

[Cutting Step]

As shown by the dashed lines in FIG. 14 (e), in the cutting step, the reflector portion 34 is cut along the thickness direction. As shown by the dash-dot lines in FIG. 15, for example, the phosphor sheet 5 is cut so that the reflector portion 34 is formed into a generally rectangular shape in plane view that surrounds each of the embedding portions 33.

By the cutting step, the reflecting layer-phosphor sheet-covered LEDs 10, each of which includes one LED 4, the embedding portion 33 that embeds the LED 4, and the reflector portion 34 that is provided around the embedding portion 33, are obtained in a state of being in close contact with the support sheet 1. That is, each of the reflecting layer-phosphor sheet-covered LEDs 10 includes the reflector portion 34. That is, the reflecting layer-phosphor sheet-covered LED 10 is a reflector portion-including reflecting layer-phosphor sheet-covered LED.

[Peeling Step]

In the peeling step, as shown in FIG. 14 (f), each of the reflecting layer-phosphor sheet-covered LEDs 10 each including the reflector portion 34 is peeled from the support sheet 1.

[Mounting Step]

In the mounting step, after the reflecting layer-phosphor sheet-covered LED 10 including the reflector portion 34 is selected in accordance with emission wavelength and luminous efficiency, as shown in FIG. I4 (g), the selected reflecting layer-phosphor sheet-covered LED 10 is mounted on the board 9. In this way, the LED device 15 is obtained.

In this way, the LED device 15 including the board 9 and the reflecting layer-phosphor sheet-covered LED 10 that is mounted on the board 9 and includes the reflector portion 34 is obtained.

According to the eleventh embodiment, the embedding-reflector sheet 64 includes the embedding portion 33 that embeds the LED 4 and the reflector portion 34 that contains a light reflecting component and is formed so as to surround the embedding portion 33, so that light emitted from the LED 4 can be also reflected by the reflector portion 34. That is, the light emitted from the LED 4 can be reflected by both the reflector portion 34 and the reflecting layer 6. Thus, the luminous efficiency of the LED device 15 can be improved.

<Modified Example>

Also, the release sheet 13 (ref: the phantom lines in FIG. 14 (c)) is provided between the flat plate portion 38 and the phosphor sheet 5 that are shown in FIG. 16 (c) to form the embedding-reflector sheet 64 in which the release sheet 13 is laminated on the upper surface thereof. Thereafter, as shown by the phantom lines in FIG. 14 (d), the embedding-reflector sheet 64 can be also, for example, subjected to flat plate pressing with respect to a plurality of the LEDs 4 and the support sheet 1.

<Twelfth Embodiment>

FIG. 17 shows process drawings for illustrating a method for producing an embedding-reflector sheet used in a twelfth embodiment of a method for producing a reflecting layer-phosphor layer-covered LED of the present invention.

In the twelfth embodiment, the same reference numerals are provided for members and steps corresponding to each of those in the eleventh embodiment, and their detailed description is omitted.

In the method for producing the embedding-reflector sheet 64 in the eleventh embodiment, as shown in FIGS. 16 (c) and 16 (d), the embedding portions 33 are formed of the phosphor sheet 5. Alternatively, for example, as shown in FIG. 17 (c), the embedding portions 33 can be also formed by potting a varnish of a phosphor resin composition into the through holes 41 without using the phosphor sheet 5.

To be specific, first, the phosphor resin composition is prepared as a varnish. To be specific, when the phosphor resin composition contains a curable resin, a varnish in an A-stage state is prepared. In this way, the phosphor resin composition in an A-stage state fills the through holes 41.

Thereafter, when the phosphor resin composition contains a curable resin, the phosphor resin composition in an A-stage state is brought into a B-stage state.

In the twelfth embodiment, the same function and effect as that of the eleventh embodiment can be achieved.

<Thirteenth Embodiment>

FIG. 18 shows process drawings for illustrating a thirteenth embodiment of a method for producing a reflecting layer-phosphor layer-covered LED of the present invention.

In the thirteenth embodiment, the same reference numerals are provided for members and steps corresponding to each of those in the eleventh and twelfth embodiments, and their detailed description is omitted.

In the eleventh embodiment, as shown in FIGS. 14 (c) and 15, the lower end portion of the embedding portion 33 is formed to be larger than the LED 4 in plane view. Alternatively, for example, as shown in FIG. 18 (c), the lower end portion of the embedding portion 33 can be formed to be the same size as that of the LED 4.

[LED Disposing Step]

Each of the embedding portions 33 is, for example, formed into a generally quadrangular pyramid trapezoidal shape in which its width is gradually reduced toward the lower side.

In order to form the embedding portions 33 shown in FIG. 18 (c), each of the extruded portions 39 referred in FIGS. 16 and 17 is formed into a generally quadrangular pyramid trapezoidal shape in which its width is gradually reduced from the lower surface of the flat plate portion 38 toward the lower side.

Also, as shown by the dash-dot lines in FIG. 18 (c), the embedding-reflector sheet 64 is disposed on the pressure-sensitive adhesive layer 3 including the LEDs 4 so that, when projected in the thickness direction, the lower end portion of each of the embedding portions 33 is overlapped with each of the LEDs 4, to be specific, the circumference end edge of the lower end portion of each of the embedding portions 33 is formed at the same position as the circumference end edge of each of the LEDs 4 in plane view.

In the thirteenth embodiment, the same function and effect as those of the eleventh and twelfth embodiments can be achieved.

<Fourteenth Embodiment>

FIG. 19 shows process drawings for illustrating a fourteenth embodiment of a method for producing a reflecting layer-phosphor layer-covered LED of the present invention. FIG. 20 shows process drawings for illustrating a method for producing the embedding-reflector sheet shown in FIG. 19 (c).

In the fourteenth embodiment, the same reference numerals are provided for members and steps corresponding to each of those in the eleventh embodiment, and their detailed description is omitted.

In the eleventh embodiment, as shown in FIG. 14 (c), each of the embedding portions 33 in the embedding-reflector sheet 64 is formed into a generally conical trapezoidal shape in which its width is gradually reduced toward the lower side. Alternatively, for example, as shown in FIG. 19 (c), each of the embedding portions 33 can be also formed into a generally column shape extending in the up-down direction (the thickness direction).

In order to form the embedding portions 33, a punching device 55 shown in FIGS. 20 (a) and 20 (b) is used.

The punching device 55 is provided with a support board 56 and a die 57 that is disposed in opposed relation to the upper side of the support board 56.

The support board 56 is, for example, formed of a metal such as stainless steel into a generally rectangular flat plate shape. Through holes 53 that pass through the support board 56 in the thickness direction are formed.

Each of the through holes 53 is formed into a generally circular shape in plane view.

The die 57 integrally includes a flat plate portion 58 and extruded portions 59 that are formed to be extruded downwardly from the flat plate portion 58.

The flat plate portion 58 is formed into the same shape as that of the flat plate portion 38 shown in FIG. 16 (a).

In the die 57, a plurality of the extruded portions 59 are disposed at spaced intervals to each other in the plane direction so as to correspond to the embedding portions 33 (ref: FIG. 20 (d)). That is, each of the extruded portions 59 is formed into the same shape and the same size as those of each of the through holes 53 in plane view, to be specific, into a generally column shape. Each of the extruded portions 59 is formed into the same shape as that of each of the embedding portions 33 (ref: FIG. 20 (d)). That is, each of the extruded portions 59 is formed into a generally rectangular shape in front sectional view and side sectional view.

In this way, the punching device 55 is configured to allow the extruded portions 59 to be capable of being inserted into the through holes 53 by the pushing down of the die 57.

The hole diameter of each of the through holes 53 and the diameter of each of the extruded portions 59 are, for example, 5 mm or more, or preferably 7 mm or more, and are, for example, 300 mm or less, or preferably 200 mm or less.

The spacer 140 is provided on the upper surface of the circumference end portion of the support board 56. The spacer 140 is, in plane view, disposed in a generally frame shape in plane view at the circumference end portion of the support board 56 so as to surround the through holes 53.

In order to form the embedding-reflector sheet 64 by the punching device 55 shown in FIGS. 20 (a) and 20 (b), first, as shown in FIG. 20 (a), the reflector sheet 42 is disposed on the support board 56. To be specific, the reflector sheet 42 is disposed on the upper surface of the support board 56 so as to cover a plurality of the through holes 53.

Next, as shown in FIG. 20 (b), the reflector sheet 42 is stamped out using the punching device 55.

To be specific, the extruded portions 59 stamp out the reflector sheet 42 by pushing down the die 57.

In this way, the through holes 41 in shapes corresponding to the extruded portions 59 are formed in the reflector sheet 42.

In this way, the reflector portion 34 is formed on the support board 56.

Next, as shown in FIG. 20 (c), the die 57 is pulled up.

Thereafter, the formed reflector portion 34 is disposed in the pressing device 135 that is provided with the support board 36 and the die 37 made of the flat plate portion 38, and includes the releasing sheet 49.

Next, the phosphor sheet 5 is disposed on the reflector portion 34.

Next, as shown by the arrows in FIG. 20 (c), and in FIG. 20 (d), the phosphor sheet 5 is pressed by the pressing device 135. In this way, the embedding portions 33 are formed in the inside of the through holes 41 in the reflector portion 34.

In this way, the embedding-reflector sheet 64 including the embedding portions 33 and the reflector portion 34 is obtained between the support board 36 and the die 37.

Thereafter, the die 37 is pulled up and subsequently, as shown in FIG. 20 (e), the embedding-reflector sheet 64 is peeled from the releasing sheet 49.

In the fourteenth embodiment, the same function and effect as that of the eleventh embodiment can be achieved.

<Fifteenth Embodiment>

FIG. 21 shows process drawings for illustrating a method for producing an embedding-reflector sheet used in a fifteenth embodiment of a method for producing a reflecting layer-phosphor layer-covered LED of the present invention.

In the fifteenth embodiment, the same reference numerals are provided for members and steps corresponding to each of those in the fourteenth embodiment, and their detailed description is omitted.

In the method for producing the embedding-reflector sheet 64 in the fourteenth embodiment, as shown in FIGS. 20 (c) and 20 (d), the embedding portions 33 are formed of the phosphor sheet 5. Alternatively, for example, as shown in FIG. 21 (c), the embedding portions 33 can be also formed by potting a varnish of a phosphor resin composition into the through holes 41 without using the phosphor sheet 5.

To be specific, the reflector portion 34 shown in FIG. 21 (b) is taken out from the punching device 55 to be subsequently, as shown in FIG. 21 (c), disposed on the upper surface of the releasing sheet 49. Then, the varnish of the phosphor resin composition is potted into the through holes 41.

In the fifteenth embodiment, the same function and effect as that of the fourteenth embodiment can be achieved.

<Sixteenth Embodiment>

FIG. 22 shows process drawings for illustrating a sixteenth embodiment of a method for producing a reflecting layer-phosphor layer-covered LED of the present invention.

In the sixteenth embodiment, the same reference numerals are provided for members and steps corresponding to each of those in the fourteenth embodiment, and their detailed description is omitted.

In the fourteenth embodiment, as shown in FIG. 19 (d), the embedding portions 33 that embed the LEDs 4, to be specific, the embedding portions 33 that cover the upper surfaces and the side surfaces of the LEDs 4 are illustrated as cover portions. Alternatively, for example, as shown in FIG. 22 (d), cover portions 43 that cover the upper surfaces of the LEDs 4 can be also illustrated.

As shown in FIG. 22 (c), the cover portions 43 are provided in a cover-reflector sheet 44 so as to be surrounded by the reflector portion 34. In the cover-reflector sheet 44, each of the cover portions 43 is formed into the same shape as that of each of the embedding portions 33 shown in FIG. 19 (c) and furthermore, is formed into the same size as that of each of the LEDs 4.

As shown in FIG. 22 (c), for example, each of the cover portions 43 is disposed on the upper surface of each of the LEDs 4 so that each of the cover portions 43 is overlapped with each of the LEDs 4 when projected in the thickness direction, to be specific, the circumference end edge of each of the cover portions 43 is formed at the same position as the circumference end edge of each of the LEDs 4 in plane view.

[Covering Step]

In the sixteenth embodiment, in the phosphor sheet covering step shown in FIG. 22 (d), each of the cover portions 43 covers the upper surface of each of the LEDs 4.

The LED 4 is pressed into the cover portion 43 by pressing of the LED 4, so that the cover portion 43 slightly expands outwardly in the plane direction. The degree of expansion thereof is subtle, so that in FIG. 22 (d), the lengths in the right-left direction of the cover portion 43 and the LED 4 after the pressing are shown to be the same.

[Curing Step]

In the sixteenth embodiment, the curing step shown in FIG. 22 (e) is performed instead of the encapsulating step shown in FIG. 19 (e).

In the curing step, the cover portions 43 are cured. The conditions of the curing step are the same as those of the above-described encapsulating step.

In the sixteenth embodiment, the same function and effect as that of the fourteenth embodiment can be achieved.

<Seventeenth Embodiment>

FIG. 23 shows process drawings for illustrating a seventeenth embodiment of a method for producing a reflecting layer-phosphor layer-covered LED of the present invention.

In the seventeenth embodiment, the same reference numerals are provided for members and steps corresponding to each of those in the first embodiment, and their detailed description is omitted.

In the first embodiment, as shown in FIG. 1 (d), in the phosphor sheet covering step, the side surfaces and the upper surfaces of the LEDs 4 are covered with the phosphor sheet 5. Alternatively, for example, as shown in FIG. 23 (d), the side surfaces only of the LEDs 4 can be covered with the phosphor sheet 5.

[Sheet Disposing Step]

As shown in FIG. 23 (c), the thickness of the prepared phosphor sheet 5 is set to be thinner than that of each of the LEDs 4, that is, set to be, for example, 95 % or less, or preferably 90 % or less, and to be, for example, 10 % or more with respect to the thickness of each of the LEDs 4. To be specific, the thickness of the phosphor sheet 5 is set to be, for example, 1000 µm or less, or preferably 800 µm or less, and to be, for example, 30 µm or more, or preferably 50 µm or more.

As shown in FIG. 23 (d), in the phosphor sheet covering step, a laminate (ref: the upper side view in FIG. 23 (c)) made of the release sheet 13 and the phosphor sheet 5 laminated on the lower surface of the release sheet 13 is pressed into the support sheet 1 including the LEDs 4 so that the lower surface of the release sheet 13 is in contact with the upper surfaces of the LEDs 4 by the pressing.

The upper surface of the phosphor sheet 5, which is pressed into gaps between a plurality of the LEDs 4, is formed to be flush with the upper surfaces of the LEDs 4. The lower surface of the phosphor sheet 5 is formed to be flush with the lower surfaces of the reflecting layers 6. That is, the thickness of the phosphor sheet 5, which is pressed into gaps between a plurality of the LEDs 4, is the same as the total thickness of each of the LEDs 4 and each of the reflecting layers 6.

The side surfaces of the LED 4 are covered with the phosphor sheet 5, while the upper surface of the LED 4 is exposed from the phosphor sheet 5.

[Cutting Step]

As shown by the dashed lines in FIG. 23 (e), the phosphor sheet 5 is cut, while the position of the LEDs 4 is checked from the upper side. To be specific, in the phosphor sheet 5, the position of the LEDs 4 is checked, while the LEDs 4 are visually confirmed from the upper side with, for example, a camera. As referred in the dashed lines in FIG, 15, the phosphor sheet 5 is cut so that the cuts 8 that define a region surrounding each of the LEDs 4 are formed in plane view.

The phosphor sheet 5 can be also cut, while the LEDs 4 are visually confirmed, in addition, with the reference marks 18 (ref: FIG. 2) as a reference.

[Peeling Step]

In FIG. 23 (f), in the peeling step, each of the reflecting layer-phosphor sheet-covered LEDs 10 is peeled from the upper surface of the pressure-sensitive adhesive layer 3. That is, each of the reflecting layer-phosphor sheet-covered LEDs 10 is peeled from the support board 2 and the pressure-sensitive adhesive layer 3 so that interfacial peeling occurs between the phosphor sheet 5 and the LEDs 4, and the pressure-sensitive adhesive layer 3.

In the seventeenth embodiment, the same function and effect as that of the first embodiment can be achieved.

In addition, in the covering step, the side surfaces of the LEDs 4 are covered with the phosphor sheet 5 so that at least the upper surfaces of the LEDs 4 are exposed from the phosphor sheet 5. Thus, in the cutting step, the LEDs 4 having the upper surfaces exposed are visually confirmed and the phosphor sheet 5 can be accurately cut corresponding to the LEDs 4. Therefore, the reflecting layer-phosphor sheet-covered LED 10 to be obtained has excellent size stability. As a result, the LED device 15 including the reflecting layer-phosphor sheet-covered LED 10 has excellent luminous stability.

<Eighteenth Embodiment>

FIG. 24 shows a perspective view of a dispenser used in an eighteenth embodiment of a method for producing a reflecting layer-phosphor layer-covered LED of the present invention.

In the eighteenth embodiment, the same reference numerals are provided for members and steps corresponding to each of those in the first embodiment, and their detailed description is omitted.

In the first embodiment, as shown in FIG. 1 (c), in the sheet disposing step that is one example of the layer disposing step, the phosphor sheet 5 that is formed in advance is illustrated as a phosphor layer. Alternatively, as referred in FIG. 24, for example, a phosphor resin composition is prepared as a varnish and the varnish is directly applied onto the support sheet 1 so as to cover a plurality of the LEDs 4, so that a phosphor layer 25 can be also formed. That is, the phosphor layer 25 can be formed from the varnish of the phosphor resin composition.

In order to form the phosphor layer 25, first, the varnish is applied onto the support sheet 1 so as to cover the LEDs 4.

In order to apply the varnish, for example, an application device such as a dispenser, an applicator, or a slit die coater is used. Preferably, a dispenser 26 shown in FIG. 24 is used.

As shown in FIG. 24, the dispenser 26 integrally includes an introduction portion 27 and an application portion 28.

The introduction portion 27 is formed into a generally cylindrical shape extending in the up-down direction and the lower end portion thereof is connected to the application portion 28.

The application portion 28 is formed into a flat plate shape extending in the right-left and the up-down directions. The application portion 28 is formed into a generally rectangular shape in side view that is long in the up-down direction. The introduction portion 27 is connected to the upper end portion of the application portion 28. The lower end portion of the application portion 28 is formed into a tapered shape in sectional side view in which the front end portion and the rear end portion are cut off. The lower end surface of the application portion 28 is configured to be capable of being pressed with respect to the upper surface of the pressure-sensitive adhesive layer 3 and the upper surfaces of the LEDs 4. Furthermore, at the inside of the application portion 28, a broad flow path (not shown) in which a varnish introduced from the introduction portion 27 gradually expands in the right-left direction as it goes toward the lower section (downwardly) is provided.

The dispenser 26 is configured to be movable relatively in the front-rear direction with respect to the support sheet I extending in the plane direction.

In order to apply the varnish to the support sheet 1 using the dispenser 26, the application portion 28 is disposed in opposed relation (pressed) to the upper surfaces of a plurality of the LEDs 4 and the varnish is supplied to the introduction portion 27. Along with this, the dispenser 26 is moved relatively toward the rear side with respect to a plurality of the LEDs 4. In this way, the varnish is introduced from the introduction portion 27 into the application portion 28 and subsequently, is broadly supplied from the lower end portion of the application portion 28 to the support sheet 1 and the LEDs 4. By the relative movement of the dispenser 26 toward the rear side with respect to a plurality of the LEDs 4, the varnish is applied onto the upper surface of the support sheet 1 in a belt shape extending in the front-rear direction so as to cover a plurality of the LEDs 4.

When the phosphor resin composition contains a curable resin, the varnish is prepared in an A-stage state. When the varnish is, for example, supplied from the application portion 28 to the support sheet I, it does not flow out of its position outwardly in the plane direction. That is, the varnish has viscous properties of keeping its position. To be specific, the viscosity of the varnish under conditions of 25°C and 1 pressure is, for example, 1,000 mPa·s or more, or preferably 4,000 mPa·s or more, and is, for example, 1,000,000 mPa·s or less, or preferably 100,000 mPa·s or less. The viscosity is measured by adjusting a temperature of the varnish to 25°C and using an E-type cone at a number of revolutions of 99 s⁻¹.

When the viscosity of the varnish is not less than the above-described lower limit, the varnish can be effectively prevented from flowing outwardly in the plane direction. Thus, it is not required to separately provide a dam member or the like in the support sheet 1 (to be specific, around a plurality of the LEDs 4), so that a simplified process can be achieved. Then, the varnish can be easily and surely applied to the support sheet 1 with a desired thickness and a desired shape with the dispenser 26.

On the other hand, when the viscosity of the varnish is not more than the above-described upper limit, the application properties (the handling ability) can be improved.

Thereafter, when the phosphor resin composition contains a curable resin, the applied varnish is brought into a B-stage state (a semi-cured state).

In this way, the phosphor layer 25 in a B-stage state is formed on the support sheet 1 (on the upper surface of the pressure-sensitive adhesive layer 3) so as to cover a plurality of the LEDs 4.

In the eighteenth embodiment, the same function and effect as that of the first embodiment can be achieved.

<Modified Example>

In the first to eighteenth embodiments, a plurality of the LEDs 4 are covered with the phosphor sheet 5. Alternatively, for example, a single piece of the LED 4 can be covered with the phosphor sheet 5.

In such a case, to be specific, in the cutting step shown in FIG. 1 (e) that is illustrated in the first embodiment, the phosphor sheet 5 around the LED 4 is trimmed (subjected to trimming) so as to have a desired size.

Alternatively, the above-described embodiments can be appropriately combined.

## Claims

1. A method for producing a reflecting layer-phosphor layer-covered LED (10) comprising:
a disposing step of disposing a reflecting layer (6) at one side in a thickness direction of a support (1);
a reflecting layer covering step of, after the disposing step, disposing an LED (4) having a terminal (31) at one surface thereof at the one side in the thickness direction of the support (1) so as to allow the one surface of the LED (4) to be covered with the reflecting layer (6); and
a phosphor layer covering step of forming a phosphor layer (5) so as to cover at least the other surface of the LED (4).

2. The method for producing a reflecting layer-phosphor layer-covered LED (10) according to claim 1, wherein
the phosphor layer is formed of a phosphor sheet.

3. The method for producing a reflecting layer-phosphor layer-covered LED (10) according to claim 1 or 2, wherein
in the disposing step, the reflecting layer (6) that is in a B-stage state is provided and
in the reflecting layer covering step, the one surface of the LED (4) is allowed to adhere to the reflecting layer (6) in a B-stage state.

4. The method for producing a reflecting layer-phosphor layer-covered LED (10) according to claim 1, 2, or 3, wherein
after the phosphor layer covering step, a peeling step in which the reflecting layer-phosphor layer-covered LED (10) is peeled from the support is further included.

5. The method for producing a reflecting layer-phosphor layer-covered LED according to claim 4, wherein
the support is a support sheet (1) and
the phosphor layer covering step further includes
a layer disposing step of disposing a phosphor layer (5) formed from a phosphor resin composition containing a curable resin and a phosphor at one side in the thickness direction of the support sheet (1) so as to cover the LED;
an encapsulating step of curing the phosphor layer (5) to encapsulate the LED (4) by the phosphor layer that is flexible; and
a cutting step of, after the encapsulating step, cutting the phosphor layer (5) that is flexible corresponding to the LED (4) to produce a reflecting layer-phosphor layer-covered LED (10).

6. The method for producing a reflecting layer-phosphor layer-covered LED (10) according to claim 5, wherein
the support sheet (1) includes a hard support board (2) and a pressure-sensitive adhesive layer (3) that is laminated at the one surface in the thickness direction of the support board (2).

7. The method for producing a reflecting layer-phosphor layer-covered LED according to claim 6, further comprising
a support board peeling step in which the support board (2) is peeled from the pressure-sensitive adhesive layer (3),
wherein the support board peeling step is performed after the cutting step and before the peeling step, or after the encapsulating step and before the cutting step, and
wherein in the peeling step, the reflecting layer-phosphor layer-covered LED (10) is peeled from the pressure-sensitive adhesive layer (3).

8. The method for producing an a reflecting layer-phosphor layer-covered LED (10) according to any of claims 4 to 7, wherein
the peeling step includes the steps of:
transferring the reflecting layer-phosphor layer-covered LED (10) to a stretchable support sheet (24) that is capable of stretching in a direction perpendicular to the thickness direction and
peeling the reflecting layer-phosphor layer-covered LED (10) from the stretchable support sheet (24), while stretching the stretchable support sheet in the direction perpendicular to the thickness direction.

9. The method for producing a reflecting layer-phosphor layer-covered LED according to claim 5, wherein
the support sheet is capable of stretching in a direction perpendicular to the thickness direction and
in the peeling step, the reflecting layer-phosphor layer-covered LED is peeled from the support sheet, while the support sheet is stretched in the direction perpendicular to the thickness direction.

10. The method for producing a reflecting layer-phosphor layer-covered LED according to claim 5, wherein
the support sheet is a thermal release sheet in which the pressure-sensitive adhesive force is capable of being reduced by heating and
in the peeling step, the support sheet is heated and the reflecting layer-phosphor layer-covered LED is peeled from the support sheet.

11. The method for producing a reflecting layer-phosphor layer-covered LED according to claim 6, 7 or 8, wherein
the pressure-sensitive adhesive force of the pressure-sensitive adhesive layer (3) is capable of being reduced by application of an active energy ray; and
in the peeling step, an active energy ray is applied from at least the one side in the thickness direction to the pressure-sensitive adhesive layer (3) and the reflecting layer-phosphor layer-covered LED (10) is peeled from the pressure-sensitive adhesive layer.

12. The method for producing a reflecting layer-phosphor layer-covered LED according to claim 6, wherein
in the hard support board (2) a through hole (21) passing through in the thickness direction is formed and the pressure-sensitive adhesive layer (3) is laminated at the one side in the thickness direction of the support board so as to cover the through hole and
in the reflecting layer covering step, the LED (4) is opposed to the through hole (21) in the thickness direction and
in the peeling step, a pressing member (14) is inserted into the through hole (21) from the other side in the thickness direction thereof and the pressure-sensitive adhesive layer (3) corresponding to the through hole (21) is pressed relatively toward the one side in the thickness direction with respect to the support board (2), so that the reflecting layer-phosphor layer-covered LED (10) is peeled from the pressure-sensitive adhesive layer (3), while the reflecting layer-phosphor layer-covered LED (10) is moved relatively to the one side in the thickness direction.

13. The method for producing a reflecting layer-phosphor layer-covered LED according to any of the preceding claims, wherein
in the disposing step, the reflecting layer (6) is provided on the entire surface at the one side in the thickness direction of the support, or by laminating a reflecting sheet formed from a reflecting resin composition on the support, or by applying a liquid reflecting resin composition to the support.

14. The method for producing a reflecting layer-phosphor layer-covered LED according to claim any of the preceding claims, wherein
the phosphor layer (64) includes a cover portion (33) that covers the LED (4) and
a reflector portion (34) that contains a light reflecting component and is formed so as to surround the cover portion (33).

15. A reflecting layer-phosphor layer-covered LED (10) obtainable by a method for producing a reflecting layer-phosphor layer-covered LED according to any of claims 1 to 14.

16. A method for producing an LED device (15) comprising the steps of:
obtaining a reflecting layer-phosphor layer-covered LED (10) by a method for producing a reflecting layer-phosphor layer-covered LED according to any of claims 4 to 14, and further including
mounting the reflecting layer-phosphor layer-covered LED (10) on a board (9) via the terminal (31).

17. An LED device (15) obtainable by a method for producing an LED device according to claim 16.

18. A method for producing an LED device obtained by a method for producing a reflecting layer-phosphor layer-covered LED according to claims 1 or 13,
wherein the phosphor layer covering step is performed before the reflecting layer covering step;
the support is a board (9); and
in the reflecting layer covering step, the LED (4) is mounted on the board (9) via the terminal.

19. An LED device obtainable by a method for producing an LED device according to claim 18.

20. A deflecting layer-phosphor layer-covered LED (10) comprising:
an LED (4) having a terminal (31) at one surface thereof,
a reflecting layer (6) formed so as to cover the one surface of the LED, and
a phosphor layer (5) formed so as to cover at least the other surface of the LED,

21. The reflecting layer-phosphor layer-covered LED according to claim 20, wherein
the phosphor layer (5) is formed so as to also cover a continuous surface that is continuous to the one surface and the other surface of the LED.
